(19) **Europäisches Patentamt / European Patent Office / Office européen des brevets**

(11) **EP 3 506 375 B1**

(12) **FASCICULE DE BREVET EUROPEEN**

(45) Date de publication et mention
de la délivrance du brevet:
**10.03.2021 Bulletin 2021/10**

(51) Int Cl.:
*H01L 35/32* *(2006.01)*  *H01L 35/34* *(2006.01)*

(21) Numéro de dépôt: **18214810.6**

(22) Date de dépôt: **20.12.2018**

(54) **DISPOSITIF THERMOELECTRIQUE ET PROCEDE DE FABRICATION DU DISPOSITIF THERMOELECTRIQUE**

THERMOELEKTRISCHE VORRICHTUNG UND HERSTELLUNGSVERFAHREN EINER SOLCHEN THERMOELEKTRISCHEN VORRICHTUNG

THERMOELECTRIC DEVICE AND METHOD FOR MANUFACTURING THE THERMOELECTRIC DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.12.2017 FR 1763343**

(43) Date de publication de la demande:
**03.07.2019 Bulletin 2019/27**

(73) Titulaire: **Commissariat à l'Énergie Atomique et aux Énergies Alternatives
75015 Paris (FR)**

(72) Inventeurs:
• **SAVELLI, Guillaume
  38180 SEYSSINS (FR)**
• **COLONNA, Jean-Philippe
  38700 CORENC (FR)**

(74) Mandataire: **INNOV-GROUP
310, avenue Berthelot
69372 Lyon Cedex 08 (FR)**

(56) Documents cités:
**EP-A1- 1 988 584     WO-A1-2009/063805
US-A1- 2015 214 459**

**Description**

**Domaine technique de l'invention**

Le domaine technique de l'invention concerne les dispositifs thermoélectriques, et plus particulièrement de type générateur d'énergie électrique à partir d'une différence de température appliquée au dispositif thermoélectrique concerné, ou de type à effet Peltier.

**Etat de la technique**

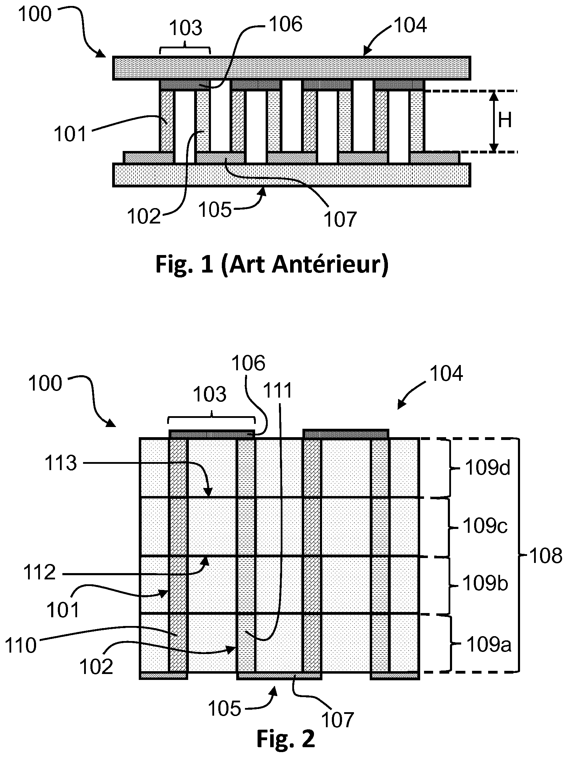

De manière connue, et comme illustré en figure 1, un dispositif thermoélectrique 100 peut comporter un ensemble de premiers plots 101 en matériau thermoélectrique et un ensemble de seconds plots 102 en matériau thermoélectrique différent du matériau thermoélectrique des premiers plots 101. Les premiers et seconds plots 101, 102 sont reliés électriquement pour former des jonctions thermoélectriques 103 entre un premier un côté 104, par exemple dit côté chaud, du dispositif thermoélectrique 100 et un deuxième côté 105, par exemple dit côté froid, du dispositif thermoélectrique 100. Chaque jonction thermoélectrique 103 comporte un des premiers plots 101 et un des seconds plots 102. Pour chaque jonction thermoélectrique 103, un élément de liaison électrique 106 permet de lier électriquement le premier plot 101 et le second plot 102 de la jonction thermoélectrique 103 correspondante, aussi appelée jonction NP dans le domaine. Des éléments de connexion 107 permettent de lier électriquement, notamment en série, les jonctions thermoélectriques 103 entre elles. Le dispositif thermoélectrique 100 de la figure 1 est composé de plusieurs premiers et seconds plots 101, 102 reliés électriquement en série et thermiquement en parallèle pour former quatre jonctions thermoélectriques 103. Notamment, dans le domaine, les premiers et seconds plots 101, 102 sont aussi respectivement appelés plots N et plots P, un plot N étant un plot à conductivité de type N : c'est-à-dire que le matériau qui le compose est à coefficient Seebeck strictement négatif, et un plot P étant un plot à conductivité de type P : c'est-à-dire que le matériau qui le compose est à coefficient Seebeck strictement positif.

De manière générale, en considérant que les dimensions (notamment hauteur, section) des premiers et seconds plots sont identiques, les performances électriques du dispositif thermoélectrique utilisé en tant que générateur d'énergie, notamment d'énergie électrique, peuvent être données de manière simplifiée par :

- une résistance électrique interne notée $R_{int}$ par exemple déterminée de la manière suivante $R_{int}$ = N x $\rho_{np}$ x H / A (notée équation (1) par la suite), avec N le nombre de jonctions thermoélectriques du dispositif thermoélectrique, H la hauteur d'un des premiers plots 101 d'une des jonctions thermoélectriques du dispositif thermoélectrique 100, cette hauteur H étant mesurée selon un axe orthogonal au premier côté 104 et au deuxième côté 105, A l'aire de la section dudit premier plot 101 prise orthogonalement à la direction dans laquelle est mesurée H, et $\rho_{np}$ correspondant à la résistivité électrique dudit premier plot 101 (cette résistivité électrique étant considérée comme identique pour chaque premier plot 101 et chaque second plot 102) ;

- une tension de sortie notée $V_{oc}$ et pouvant être déterminée de la manière suivante $V_{oc}$ = N x $S_{np}$ x $\Delta T$ (notée équation (2) par la suite), avec $S_{np}$ le coefficient Seebeck associé à l'une des jonctions thermoélectriques du dispositif thermoélectrique, $S_{np}$ = ($S_p$ - $S_n$), $\Delta T$ la différence de température effective entre le premier côté 104 et le deuxième côté 105 à laquelle les jonctions thermoélectriques sont soumises, N le nombre de jonctions thermoélectriques du dispositif thermoélectrique, $S_p$ le coefficient Seebeck du matériau de type P utilisé pour former par exemple chaque second plot 102, et $S_n$ le coefficient Seebeck du matériau de type N utilisé pour former chaque premier plot 101 ;

- une puissance électrique utile $P_u$ avec

$$P_u = \frac{V_{oc}^2}{4 \times R_{int}} \quad \text{(notée équation (3) par la suite).}$$

L'équation (1) néglige les résistances de contact et les résistances des connexions métalliques (éléments de connexion 107 et éléments de liaison 106) qui ont généralement des contributions négligeables devant les résistances des plots N et P. Par « résistance », on entend la résistance électrique.

L'architecture du dispositif thermoélectrique 100 représenté en figure 1 est de type technologie 3D (pour trois dimensions) car elle permet, dans le cadre de la génération d'énergie électrique, d'exploiter une source chaude (placée côté chaud) et une source froide (placée côté froid) agencées de manière opposée, notamment orthogonalement, à la direction de mesure de la hauteur de chacun des premiers et seconds plots 101, 102. Une source froide présente une température strictement inférieure à la température que présente la source chaude. Autrement dit, les sources chaude et froide peuvent s'étendre de part et d'autre d'une plaque (ou substrat), selon son épaisseur, dans laquelle les jonctions thermoélectriques sont formées. Une telle architecture a l'avantage de présenter une résistance électrique faible du fait que la hauteur H de chacun des premiers et seconds plots 101, 102 est généralement de quelques micromètres, c'est-à-dire comprise entre 1 $\mu$m et 100 $\mu$m, dans le domaine de la microélectronique. Cependant, cette architecture présente l'inconvénient qu'il est difficile d'obtenir une différence de température satisfaisante pour générer une tension de sortie élevée puisque cette dernière est fonction de la différence de température dépendant de la température de la source chaude et de la source froide. En effet, plus la source chaude et la source froide sont proches, plus il est difficile d'obtenir une différence de température élevée à exploiter dans le cadre de l'effet Seebeck.

En ce sens, on comprend qu'il existe un besoin d'améliorer la tension de sortie du dispositif thermoélectrique en particulier lorsque celui-ci est un générateur pour la production d'énergie électrique en exploitant une différence de température à laquelle est soumis le dispositif thermoélectrique.

Un dispositif thermoélectrique peut fonctionner en mode générateur électrique, aussi appelé mode Seebeck, ou en mode refroidisseur, aussi appelé mode Peltier. En fait, en mode Seebeck, le dispositif thermoélectrique 100 permet d'exploiter une différence de température induisant un gradient thermique aux bornes de chacune des jonctions thermoélectriques pour permettre la génération d'énergie électrique, comme une tension, par les jonctions thermoélectriques. Les bornes d'une jonction thermoélectrique correspondent à ses deux extrémités géométriques opposées respectivement proximale du premier côté 104 et proximale du deuxième côté 105. En mode Peltier, le dispositif thermoélectrique 100 peut être alimenté en énergie électrique de sorte à refroidir l'un de ses côtés (premier côté 104 ou deuxième côté 105), cette alimentation électrique alimente alors les jonctions thermoélectriques qui permettent le refroidissement recherché.

De manière plus générale, il existe un besoin d'améliorer la différence de température exploitable par le dispositif thermoélectrique lorsque ce dernier fonctionne en mode Seebeck, ou générée par le dispositif thermoélectrique lorsque ce dernier fonctionne en mode Peltier. La différence de température est dite améliorée lorsqu'on tend à l'élever, ou à la conserver la plus haute possible, en fonction des conditions d'utilisation du dispositif thermoélectrique.

La demande de brevet européen publiée sous le numéro EP 1 988 584 A1 décrit un dispositif thermoélectrique. La demande internationale de brevet publiée sous le numéro WO 2009/063805 A1 décrit un dispositif thermoélectrique.

**Objet de l'invention**

L'invention a pour but d'améliorer la différence de température entre un côté chaud d'un dispositif thermoélectrique et un côté froid du dispositif thermoélectrique, notamment pour augmenter le gradient thermique aux bornes d'au moins une jonction thermoélectrique.

On tend vers ce but grâce à un dispositif thermoélectrique comportant :

- au moins une jonction thermoélectrique, ladite jonction thermoélectrique comportant un premier plot et un second plot relié électriquement au premier plot,
- un empilement de substrats, chaque substrat comportant au moins un premier élément et au moins un second élément, le premier élément et le second élément étant formés dans l'épaisseur dudit substrat,

l'empilement de substrats étant tel que :

- le premier plot de la jonction thermoélectrique comporte un empilement de premiers éléments,
- le second plot de la jonction thermoélectrique comporte un empilement de seconds éléments.

L'empilement de substrats comporte au minimum trois substrats, et tout substrat de l'empilement de substrats, situé entre deux substrats d'extrémité de l'empilement de substrats, comporte :

- une première face,
- une deuxième face opposée à sa première face,
- une première couche en matériau diélectrique délimitant une partie de la première face dudit substrat,
- une deuxième couche en matériau diélectrique délimitant une partie de la deuxième face dudit substrat, les première et deuxième couches en matériau diélectrique dudit substrat étant traversées par les premier et second plots.

Grâce à l'empilement de substrats, il est possible d'adapter la distance de séparation entre deux côtés opposés (formant respectivement un côté chaud et un côté froid) du dispositif thermoélectrique lors de la conception du dispositif thermoélectrique. Ceci permet d'améliorer la différence de température, entre ces deux côtés opposés, qu'il est possible d'exploiter si le dispositif thermoélectrique fonctionne en mode Seebeck, ou qu'il est possible de générer si le dispositif thermoélectrique fonctionne en mode Peltier. Par ailleurs, l'empilement de substrats permet d'assurer un assemblage du dispositif thermoélectrique compatible avec les techniques de la microélectronique pour obtenir in fine un dispositif thermoélectrique de faible encombrement. Grâce à ce faible encombrement, il est, par exemple, possible d'intégrer plus facilement le dispositif thermoélectrique dans un composant électronique tout en bénéficiant, le cas échéant, d'un rendement amélioré de production d'énergie électrique du fait de l'amélioration de la différence de température à exploiter pour ladite production d'énergie électrique.

Le dispositif thermoélectrique peut comporter une ou plusieurs des caractéristiques suivantes :

• pour tout substrat de l'empilement de substrats, situé entre les deux substrats d'extrémité de l'empilement de substrats, les première et deuxième couches en matériau diélectrique dudit substrat sont formées sur, et notamment de part et d'autre, d'un support dudit substrat ;
• pour tout substrat de l'empilement de substrats, situé entre les deux substrats d'extrémité de l'empilement de substrats, la première couche en matériau diélectrique dudit substrat présente une conductivité électrique strictement inférieure à celle du support sur lequel elle est formée, et la deuxième couche en matériau diélectrique dudit substrat présente une conductivité électrique strictement inférieure à celle du support sur lequel elle est formée ;

- la jonction thermoélectrique comporte un élément de liaison électriquement conducteur relié à une portion en siliciure du premier plot de la jonction thermoélectrique et à une portion en siliciure du second plot de la jonction thermoélectrique ;
- chaque substrat de l'empilement de substrats comporte des vias traversants formant les premier et second éléments dudit substrat ;
- le dispositif thermoélectrique comporte :

  - des premiers et des seconds plots,
  - une pluralité de jonctions thermoélectriques comportant chacune un des premiers plots et un des seconds plots,

  et chaque substrat comporte des premiers et des seconds éléments, l'empilement de substrats étant tel que :

  - chaque premier plot comporte un empilement de premiers éléments,
  - chaque second plot comporte un empilement de seconds éléments ;

- les jonctions thermoélectriques sont reliées électriquement en série ;
- le dispositif thermoélectrique comporte des ensembles de jonctions thermoélectriques tels que, au sein de chaque ensemble de jonctions thermoélectriques, les jonctions thermoélectriques dudit ensemble sont reliées électriquement en parallèle, lesdits ensembles de jonctions thermoélectriques étant reliés électriquement en série ;
- les substrats de l'empilement de substrats sont liés par des liaisons covalentes.

L'invention est aussi relative à un procédé de fabrication d'un dispositif thermoélectrique comprenant au moins une jonction thermoélectrique, ledit procédé de fabrication comportant :

- une étape de fourniture de substrats, chaque substrat fourni comportant au moins un premier élément et au moins un second élément formés dans son épaisseur,
- une étape de formation d'un empilement de substrats en utilisant les substrats fournis d'où il résulte la formation d'un premier plot de la jonction thermoélectrique et d'un second plot de la jonction thermoélectrique, le premier plot comportant un empilement de premiers éléments et le second plot comportant un empilement de seconds éléments,
- une étape de formation d'une connexion électrique de la jonction thermoélectrique, ladite connexion électrique reliant électriquement le premier plot au second plot.

L'empilement de substrats comporte au minimum trois substrats, et tout substrat de l'empilement de substrats, situé entre deux substrats d'extrémité de l'empilement de substrats, comporte :

- une première face,
- une deuxième face opposée à sa première face,
- une première couche en matériau diélectrique délimitant une partie de la première face dudit substrat,
- une deuxième couche en matériau diélectrique délimitant une partie de la deuxième face dudit substrat, les première et deuxième couches en matériau diélectrique dudit substrat étant traversées par les premier et second plots.

Le procédé de fabrication peut comporter une ou plusieurs des caractéristiques suivantes :

- chaque substrat fourni est tel que :

  - ledit substrat comporte une première face dans laquelle sont formés des trous borgnes, les premier et second éléments dudit substrat étant formés dans les trous borgnes de telle sorte que la première face dudit substrat comprend des parties délimitées par les premier et second éléments,
  - ledit substrat comporte une deuxième face opposée à sa première face,

  et l'étape de formation de l'empilement de substrats comporte :

  - une étape de formation d'un assemblage comprenant une étape de mise en contact des premières faces de premier et deuxième substrats issus des substrats fournis,
  - une étape de modification du deuxième substrat de l'assemblage d'où il résulte que sa deuxième face présente des parties délimitées par les premier et second éléments du deuxième substrat, ladite deuxième face du deuxième substrat tel que modifié formant une face de connexion de l'assemblage,
  - une étape de modification du premier substrat pour former un substrat d'extrémité de l'empilement de substrats ;

- le nombre de substrats fournis étant supérieur ou égal à 3, le procédé de fabrication comporte, après l'étape de modification du deuxième substrat et pour chaque substrat fourni séparé de l'assemblage, dit substrat à ajouter à l'assemblage, une étape de modification de l'assemblage comportant :

- une étape d'ajout du substrat à ajouter à l'assemblage par report de la première face dudit substrat à ajouter sur la face de connexion de l'assemblage,
- une étape de modification dudit substrat ajouté à l'assemblage d'où il résulte que sa deuxième face présente des parties délimitées par les premier et second éléments du substrat ajouté à l'assemblage, ladite deuxième face formant, au terme de la modification dudit substrat ajouté, une nouvelle face de connexion de l'assemblage.

**Description sommaire des dessins**

L'invention sera mieux comprise à la lecture de la description détaillée qui va suivre d'au moins un mode particulier de réalisation, donnée uniquement à titre d'exemple non limitatif et faite en se référant aux dessins dans lesquels :

- La figure 1 représente, selon une vue en coupe, un dispositif thermoélectrique selon l'art antérieur ;
- La figure 2 représente de manière schématique une vue en coupe d'un dispositif thermoélectrique selon un mode de réalisation de l'invention ;
- La figure 3 représente de manière plus détaillée une vue en coupe d'un dispositif thermoélectrique selon un mode de réalisation plus détaillé de l'invention ;
- La figure 4 représente une vue éclatée d'un empilement de substrats permettant de former le dispositif thermoélectrique ;
- La figure 5 représente un exemple de liaison entre jonctions thermoélectriques du dispositif thermoélectrique ;
- Les figures 6 à 21 illustrent des étapes du procédé de fabrication du dispositif thermoélectrique.

Dans ces figures, les mêmes références sont utilisées pour désigner les mêmes éléments.

Par ailleurs, les éléments représentés sur les figures ne sont pas nécessairement à l'échelle de manière à privilégier la clarté des figures.

**Description détaillée**

Comme évoqué dans la partie état de la technique, le dispositif thermoélectrique peut fonctioner en mode Seebeck : le dispositif thermoélectrique est alors un générateur d'énergie électrique, ou en mode Peltier : le dispositif thermoélectrique est alors un générateur d'énergie thermique. Ces modes de fonctionnement sont bien connus de l'homme du métier, et ne seront pas décrits plus en détails.

Dans la présente description, par « à base de », on entend « comporte majoritairement » ou est « constitué par ».

Dans la présente description, pour une dimension comprise entre deux valeurs, les bornes formées par ces deux valeurs sont incluses.

Par « sensiblement orthogonal », on entend dans la présente description « orthogonal » ou « orthogonal à plus ou moins 10% de tolérance ».

Par « sensiblement parallèle », on entend dans la présente description « parallèle» ou « parallèle à plus ou moins 10% de tolérance ».

Dans la présente description, une dimension donnée selon une direction est mesurée sensiblement parallèlement à cette direction.

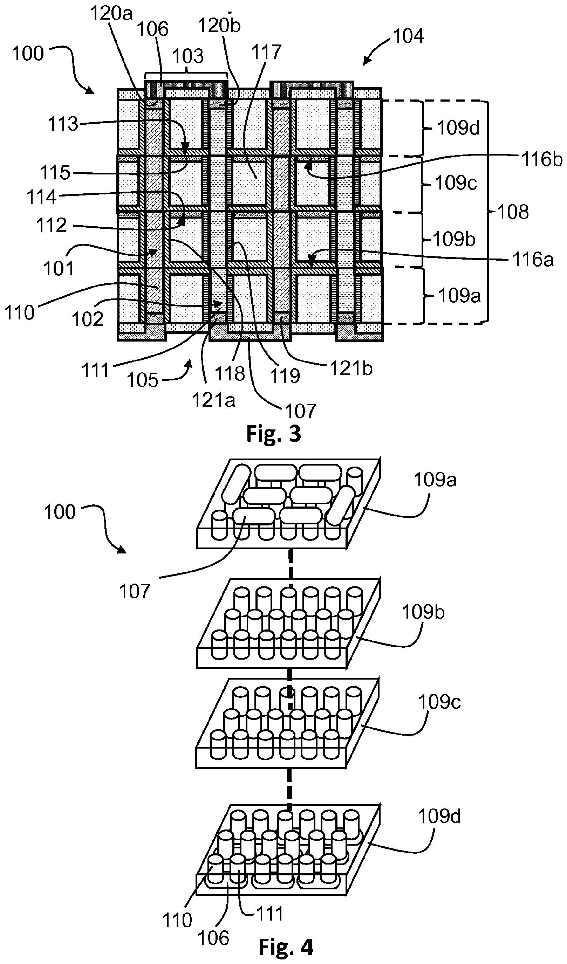

Comme illustré en figures 2 et 3, le dispositif thermoélectrique 100 comporte au moins une jonction thermoélectrique 103. La jonction thermoélectrique 103 comporte un premier plot 101 et un second plot 102. Le second plot 102 est relié électriquement au premier plot 101. La liaison électrique entre le premier plot 101 et le second plot 102 peut, par exemple, être formée par un élément de liaison électrique 106. L'élément de liaison électrique 106 peut être en matériau métallique, ou en un alliage métallique. Par exemple l'élément de liaison 106 peut être en un matériau choisi parmi l'aluminium, le cuivre avec un alliage SnAg, le nickel avec de l'or, et le titane. De préférence, la jonction thermoélectrique 103 est agencée entre un premier côté 104 du dispositif thermoélectrique et deuxième côté 105 du dispositif thermoélectrique 100. Une différence de température entre les premier et deuxième côtés 104, 105 peut être générée, ou exploitée, par le dispositif thermoélectrique 100 (et donc par la jonction thermoélectrique 103) selon son mode de fonctionnement. Notamment, le premier côté 104 est un « côté chaud » et le deuxième côté 105 est un « côté froid », l'inverse est bien entendu possible. La différence de température est observable entre le premier côté 104 et le deuxième côté 105, le gradient de température aux bornes de la, ou de chacune des, jonctions thermoélectriques est dépendant de cette différence de température. Selon l'invention, le dispositif thermoélectrique 100 comporte un empilement 108 de substrats. Au sens de la présente description, un « substrat » peut être une plaque, une puce microélectronique (on parle alors de substrat fonctionnalisé de telle sorte à former la puce microélectronique), ou encore un « panel » en langue anglaise correspondant à un substrat généralement rectangulaire permettant de faire du « panel level packaging » en langue anglaise : on parle alors aussi de « packaging » de panneaux rectangulaires. Chaque substrat 109a, 109b, 109c, 109d de l'empilement 108 de substrats comporte au moins un premier élément 110 et au moins un second élément 111. Le premier élément 110 et le second élément 111 sont formés dans l'épaisseur du substrat 109a, 109b, 109c, 109d correspondant. L'empilement 108 de substrats est tel que le premier plot 101 de la jonction thermoélectrique 103 comporte un empilement de premiers éléments 110, et que le second plot 102 de la jonction thermoélectrique 103 comporte un empilement de seconds éléments 111. Notamment, chaque premier élément 110 du premier plot 101 est en contact avec au moins un, ou au plus deux, premiers éléments 110 du premier plot 101, et chaque second élément 111 du second plot 102 est en contact avec au moins un, ou au plus, deux seconds éléments 111 du second plot 102. Les premiers éléments 110 sont empilés selon une direction sensiblement parallèle à la direction d'empilement des substrats. Les seconds éléments 111 sont empilés selon une direction sensiblement parallèle à la direction d'empilement des substrats 109a, 109b, 109c, 109d. L'empilement 108 de substrats présente des première et deuxième faces opposées selon la direction d'empilement, la première face de l'empilement 108 de substrats étant proximale du (ou correspondant au) premier côté 104 et la deuxième face de l'empilement 108 de substrats étant proximale du (ou correspondant au) deuxième côté 105. On comprend alors que la différence de température évoquée ci-dessus est mesurable de part et d'autre de l'empilement 108 de substrats selon la direction d'empilement des substrats 109a, 109b, 109c, 109d. Grâce à l'empilement 108 de substrats, il est possible d'adapter, lors de la conception du dispositif thermoélectrique 100, la dimension séparant le premier côté 104 du deuxième côté 105 : ceci permet, plus la distance entre le premier côté 104 et le deuxième côté 105 est importante, de bénéficier d'une différence de température plus importante à exploiter en mode Seebeck, ou de permettre la génération d'une différence de température plus importante en mode Peltier. Autrement dit, la différence de température peut être améliorée grâce à l'empilement 108 de substrats. En particulier, les premier et second plots 101, 102 présentent une dimension, mesurée selon la direction d'empilement des substrats 109a, 109b, 109c, 109d, appelée hauteur. Selon leur hauteur, les premier et second plots 101, 102 comportent chacun deux extrémités opposées. Les extrémités des premier et second plots 101, 102 proximales du premier côté 104 sont reliés électriquement entre elles, notamment par l'élément de liaison 106 agencé par exemple à la première face de l'empilement 108 de substrats, pour former la jonction thermoélectrique 103. Le cas échéant, les extrémités des premier et second plots 101, 102 proximales du deuxième côté 105 permettent de relier électriquement des jonctions thermoélectriques distinctes par un élément de connexion 107, notamment agencé par exemple à la deuxième face de l'empilement 108 de substrats, ou d'utiliser un élément de connexion pour former une borne de connexion du dispositif thermoélectrique 100.

Chaque jonction thermoélectrique 103 du dispositif thermoélectrique 100 est configurée pour générer un effet thermoélectrique, notamment lors du fonctionnement du dispositif thermoélectrique 100. En mode Seebeck, l'effet thermoélectrique est tel que la, ou les, jonctions thermoélectriques permettent la génération d'une énergie électrique lorsqu'elles sont soumises à une différence de température appliquée au dispositif thermoélectrique, notamment entre ses premier et deuxième côtés 104, 105. En mode Peltier, l'effet thermoélectrique est tel que la, ou les, jonctions thermoélectriques permettent la génération d'une énergie thermique (différence de température entre les premier et deuxième côtés 104, 105) lorsqu'elles sont soumises à une énergie électrique alimentant électriquement lesdites jonctions thermoélectriques.

Comme visible en figures 2 et 3, chaque substrat 109a, 109b, 109c, 109d au sens de la présente description peut comporter des première et deuxième faces opposées 112, 113, et un contour (non représenté) reliant la première face 112 à la deuxième face 113. Les première et deuxième faces 112, 113 de chaque substrat 109a, 109b, 109c, 109d présentent chacune une surface strictement supérieure à celle du contour. Les première et deuxième faces 112, 113 de chaque substrat 109a, 109b, 109c, 109d sont séparées d'une distance formant l'épaisseur dudit substrat.

Par « premier et second éléments 110, 111 formés dans l'épaisseur du substrat », on entend que ces premier et second éléments 110, 111 sont formés au sein du substrat correspondant, et qu'ils n'en font préférentiellement pas saillie. Ces premier et second éléments 110, 111 relient, pour un substrat donné, la première face 112 de ce substrat à la deuxième face 113 de ce substrat de sorte à en former des parties.

L'empilement 108 de substrats est notamment formé selon une direction sensiblement orthogonale aux première et deuxième faces 112, 113 de chacun des substrats 109a, 109b, 109c, 109d de l'empilement 108 de substrats. Autrement dit, les substrats 109a, 109b, 109c, 109d sont empilées selon leur épaisseur.

L'empilement 108 de substrats comporte au moins trois substrats. Sur les figures 2 et 3, l'empilement 108 de substrats comporte quatre substrats 109a, 109b, 109c, 109d. L'empilement 108 de substrats comporte alors deux substrats d'extrémité 109a, 109d de l'empilement 108 de substrats. Les substrats d'extrémité 109a, 109b correspondent aux substrats les plus distants l'un de l'autre et appartenant à l'empilement 108 de substrats. Le cas échéant, l'empilement 108 de substrats comporte un ou plusieurs substrats 109b, 109c, dits « substrats intercalaires », situés entre les deux substrats d'extrémité 109a, 109b.

Cette configuration à empilement 108 de substrats permet en outre de former le dispositif thermoélectrique 100 en utilisant des technologies de la microélectronique, il est ainsi possible de former un dispositif thermoélectrique 100 dont l'encombrement est limité, et pouvant ainsi facilement être intégré à des composants microélectroniques. Notamment, comme il le sera décrit ci-après, cette configuration est tout particulièrement adaptée lorsque le dispositif thermoélectrique 100 est obtenu par des techniques de la microélectronique comprenant la formation de vias traversants.

Les notions de chaud et de froid liées aux premier et deuxième côtés 104, 105 du dispositif thermoélectrique 100 permettent de définir où sera formée la différence de température à exploiter par la jonction thermoélectrique 103 pour générer de l'énergie électrique en cas de fonctionnement en mode Seebeck. Alternativement, les notions de chaud et de froid liées aux premier et deuxième côtés 104, 105 du dispositif thermoélectrique 100 permettent de définir où sera formé la différence de température pour refroidir, ou réchauffer, volontairement un côté du dispositif thermoélectrique 100 lorsque le dispositif thermoélectrique 100 fonctionne en mode Peltier.

Dans la présente description, la jonction thermoélectrique 103 définit un ensemble comportant deux plots reliés électriquement entre eux, de préférence à l'une de leurs extrémités proximales de l'un des premier et deuxième côtés 104, 105, par exemple en utilisant l'élément de liaison 106 électrique.

En particulier, le premier plot 101 et le second plot 102 sont chacun formé en, ou comportent chacun un, matériau thermoélectrique. Il en résulte que les premiers éléments 110 sont notamment formés en matériau thermoélectrique identique à celui du premier plot 101 puisque les premiers éléments 110 forment le premier plot 101, et que les seconds éléments 111 sont notamment formés en matériau thermoélectrique identique à celui du second plot 101 puisque les seconds éléments 111 forment le second plot 102. Le matériau thermoélectrique du premier plot 101 présente des propriétés thermoélectriques différentes de celles du matériau thermoélectrique du second plot 102 pour assurer l'effet Peltier, ou Seebeck, recherché. De préférence, le premier plot 101 de la jonction thermoélectrique 103 est à base de matériau thermoélectrique de type N, et le second plot 102 de la jonction thermoélectrique 103 est à base de matériau thermoélectrique de type P. Le matériau thermoélectrique de type N permet de favoriser le déplacement des électrons. Le matériau thermoélectrique de type P permet de favoriser le déplacement des trous. Selon une autre formulation le matériau thermoélectrique de type N présente un coefficient Seebeck strictement négatif, et le matériau thermoélectrique de type P présente un coefficient Seebeck strictement positif. De préférence, pour favoriser le déplacement des électrons, le matériau thermoélectrique du premier plot 101 est un, ou est à base d'un, matériau dopé de type N, comme par exemple un alliage silicium-germanium (SiGe) dopé par du phosphore ou du polysilicium dopé de type N. De manière générale, le dopant de type N peut être du phosphore ou de l'arsenic. De préférence, pour favoriser le déplacement des trous, le matériau thermoélectrique du second plot 102 est un, ou est à base d'un, matériau dopé de type P, comme par exemple un alliage silicium-germanium (SiGe) dopé par du bore ou encore du polysilicium dopé de type P. De manière générale, le dopant de type P est préférentiellement du bore. Ces matériaux thermoélectriques sont tout particulièrement adaptés au domaine de la microélectronique. Par dopage, on parle de dopage électrique.

Chaque substrat 109a, 109b, 109c, 109d de l'empilement 108 de substrats peut présenter une épais-seur comprise entre 10μm à 10mm en fonction du type de substrat. Par exemple, si les substrats sont formés à partir de tranches de semi-conducteur aussi appelées « wafers » en langue anglaise, l'épaisseur de chaque substrat 109a, 109b, 109c, 109d du dispositif thermoélectrique 100 peut être comprise entre 100μm et 800μm. La gamme donnée de 10μm à 10mm permet de couvrir une épaisseur de puce à une épaisseur de « panel ». Les substrats 109a, 109b, 109c, 109d peuvent présenter des épaisseurs identiques, ou similaires selon un degré de tolérance par exemple compris entre plus ou moins 10% d'une valeur d'épaisseur de référence comprise dans la gamme d'épaisseur donnée ci-dessus. L'épaisseur concernant les substrats 109a, 109b, 109c, 109d donnée ci-dessus est tout particulièrement adaptée au domaine de la microélectronique, et permet de miniaturiser le dispositif thermoélectrique 100. En ce sens, parallèlement à la direction d'empilement des substrats 109a, 109b, 109c, 109d, chacun des premiers et seconds éléments 110, 111 peut présenter une dimension comprise entre 10μm à 10mm, cette dimension étant notamment égale à l'épaisseur du substrat 109a, 109b, 109c, 109d qui comporte les premier et second éléments 110, 111. Par ailleurs, de manière sensiblement orthogonale à la direction d'empilement des substrats 109a, 109b, 109c, 109d, les premiers et seconds éléments 110, 111 peuvent présenter chacun un diamètre compris, ou des dimensions circonscrites dans un cercle de diamètre compris, entre 100nm et 1mm et plus particulièrement entre 1μm et 50μm. Les dimensions des premiers et seconds éléments 110, 111 peuvent être adaptées pour influer sur la résistance interne électrique du dispositif thermoélectrique 100 selon l'équation (1), par exemple pour optimiser la puissance électrique utile (équation (3)) du dispositif thermoélectrique 100 en fonction de son application et selon l'équation (2).

De préférence, et comme illustré en figures 2 et 3, le dispositif thermoélectrique 100 peut comporter des premiers et des seconds plots 101, 102, et une pluralité de jonctions thermoélectriques 103 comportant chacune un des premiers plots 101 et un des seconds plots 102. Il résulte de la présence de la pluralité de jonctions thermoélectriques 103 que chaque substrat 109a, 109b, 109c, 109d comporte des premiers et seconds éléments 110, 111, et que l'empilement 108 de substrats est tel que chaque premier plot 101 comporte un empilement de premiers éléments 110, et que chaque second plot 102 comporte un empilement de seconds éléments 111. Cette configuration à une pluralité de jonctions thermoélectriques permet par exemple d'ajuster la résistance interne (équation (1)) du dispositif thermoélectrique 100, la tension de sortie (équation (2)) du dispositif thermoélectrique 100, notamment en vue d'influer sur la puissance utile (équation (3)) du dispositif thermoélectrique 100. Sur les figures 2 et 3, il est représenté deux jonctions thermoélectriques 103 reliées électriquement en série par exemple en utilisant l'élément de connexion électrique 107 pouvant présenter les mêmes caractéristiques (par exemples même dimensions et/ou même matériau) que l'élément de liaison 106. Bien entendu, ceci n'est pas limitatif dans le sens où le nombre de jonctions thermoélectriques 103, et donc de premiers et seconds plots 101, 102, peut être adapté par l'homme du métier notamment selon la destination d'utilisation du dispositif thermoélectrique 100. Ainsi, tout ce qui est décrit dans la présente description en relation avec une jonction thermoélectrique 103 peut s'appliquer à chaque jonction thermoélectrique (et donc à ce qui la compose) du dispositif thermoélectrique 100 lorsqu'il en comprend plusieurs. Dès lors, tout ce qui s'applique à un premier plot peut s'appliquer à chaque premier plot, et tout ce qui s'applique à un second plot peut s'appliquer à chaque second plot. Ainsi, pour un substrat 109a, 109b, 109c, 109d donné tout ce qui s'applique pour des premier et second éléments 110, 111 peut s'appliquer à des premiers et seconds éléments 110, 111. Notamment, chaque premier plot 101 appartient à une unique jonction thermoélectrique 103, et chaque second plot 102 appartient à une unique jonction thermoélectrique 103, ceci étant notamment valable pour des jonctions thermoélectriques reliées électriquement en série.

Il a été évoqué ci-dessus que le dispositif thermoélectrique 100 pouvait préférentiellement être issu de la technologie de la microélectronique. En ce sens, chaque substrat 109a, 109b, 109c, 109d de l'empilement de substrats peut comporter des vias traversants, aussi appelés trous de liaison, ou trous d'interconnexion, dans le domaine de la microélectronique. Un inconvénient des vias traversants est que leur formation respecte un ratio de diamètre sur profondeur. Un tel ratio peut être que pour un diamètre du via de 10, la profondeur du via est limitée à 200. En fait, ce ratio est à associer à l'épaisseur que l'on sait déposer de matériau thermoélectrique, par exemple pour le dépôt de poly-SiGe dopé en tant que matériau thermoélectrique, il est possible de déposer une couche de $5\mu m$ ce qui limite ensuite le diamètre du trou à $10\mu m$ et sa profondeur à $200\mu m$. En ce sens, l'utilisation d'un seul substrat ne permet pas d'obtenir la dimension souhaitée pour améliorer la différence de température : l'empilement 108 de substrats permet de lever cette limitation en empilant les vias pour former des premier et second plots 101, 102 dont la dimension, selon la direction d'empilement des substrats 109a, 109b, 109c, 109d, n'est plus limitée, et peut être adaptée à la demande lors de la fabrication du dispositif thermoélectrique 100. Un via traversant est en fait un trou formé dans le substrat et comblé par un matériau adapté, ici un matériau thermoélectrique permettant de former dans le trou concerné, le cas échéant, le premier élément 110 ou le second élément 111. Autrement dit, les vias traversants forment les premier et second éléments 110, 111 de chaque substrat 109a, 109b, 109c, 109d. Les trous d'interconnexion, usuellement utilisés en microélectronique pour lier des couches entre elles ont pour fonction de véhiculer un signal codé entre éléments électroniques formés à divers niveaux. Selon une réalisation de l'invention, la fonction des trous d'interconnexion est donc avantageusement détournée en vue de former des premier et second plots 101, 102 de jonction thermoélectrique 103 selon une dimension adaptée permettant d'améliorer la différence de température entre les premier et deuxième côtés 104, 105 du dispositif thermoélectrique 100.

De préférence, les substrats 109a, 109b, 109c, 109d de l'empilement 108 de substrats sont liés par des liaisons covalentes. Les liaisons covalentes sont notamment obtenues par collage direct aussi appelé collage moléculaire, puis par recuit. Un collage direct ou collage moléculaire consiste à mettre en contact des portions de même matériaux issus de substrats différents à assembler entre eux. Ces liaisons covalentes permettent avantageusement d'assurer un assemblage mécanique efficace de l'empilement 108 de substrats. Notamment, pour chaque couple de substrats en contact l'un avec l'autre au sein de l'empilement 108 de substrats :

- les premiers éléments 110 des substrats dudit couple de substrats, et appartenant à un même premier plot 101, sont liés entre eux par liaisons covalentes, et
- les seconds éléments 111 des substrats dudit couple de substrats, et appartenant à un même second plot 102, sont liés entre eux par liaisons covalentes,

ceci présente l'avantage d'assurer une continuité électrique satisfaisante entre les premiers éléments 110 liés par liaisons covalentes, et entre les seconds éléments 111 liés par liaisons covalentes.

Selon une réalisation particulière illustrée en figure 3, l'empilement 108 de substrats comporte au minimum trois substrats (quatre substrats 109a, 109b, 109c, 109d sont représentés dans l'exemple illustré en figure 3). Tout substrat 109b, 109c de l'empilement 108 de substrats (formant un substrat intercalaire au sens tel que décrit précédemment), situé entre deux substrats d'extrémité 109a, 109d de l'empilement 108 de substrats, comporte : la première face 112 ; la deuxième face 113 opposée à sa première face 112 ; une première couche 114 en matériau diélectrique délimitant une partie de la première face 112 dudit substrat ; et une deuxième couche 115 en matériau diélectrique délimitant une partie de la deuxième face 113 dudit substrat, les première et deuxième couches 114, 115 en matériau diélectrique dudit substrat étant traversées par les premier et second plots 101, 102. Cette réalisation particulière permet de former des couches en matériau diélectrique entre le premier côté 104 et le deuxième côté 105, c'est-à-dire transversalement aux premier et second plots 101, 102 et donc sensiblement parallèles aux premier et deuxième côtés 104, 105, ces couches en matériau diélectrique 114, 115 participent à une isolation thermique en vue d'améliorer le fonctionnement du dispositif thermoélectrique 100. En effet, grâce à ces couches en matériau diélectrique, la différence de température entre le premier côté 104 et le deuxième côté 105 peut être améliorée en limitant la diffusion de chaleur entre ces premier et deuxième côtés 104, 105. Les première et deuxième faces 112, 113 d'un même substrat intercalaire de l'empilement 108 de substrats sont respectivement liées à deux autres substrats de l'empilement 108 de substrats, notamment par liaisons covalentes. D'autres parties de la première face 112 et de la deuxième face 113 d'un même substrat intercalaire sont délimitées par les premier et second éléments 110, 111 qui participent, avec la couche en matériau diélectrique concernée (la première couche 114 ou la deuxième couche 115) à former la surface de la première face 112, ou la surface de la deuxième face 113. Notamment, les substrats d'extrémité 109a, 109d peuvent aussi comporter chacune une face d'assemblage 116a, 116b dont une partie est délimitée par une couche en matériau diélectrique, et des parties sont délimités par les premier et second éléments 110, 111 du substrat d'extrémité 109a, 109b. La face d'assemblage 116a du substrat d'extrémité 109a est en contact avec la première face 112 du substrat 109b, et la face d'assemblage 116b du substrat d'extrémité 109d est en contact avec la deuxième face 113 du substrat 109c. Ainsi, on comprend qu'un avantage de ces couches en matériau diélectrique est qu'elles participent aux liaisons covalentes entre substrats. Un autre avantage de ces couches 114, 115 en matériau diélectrique est qu'elles permettent de former des barrières thermiques sensiblement orthogonales à la direction d'empilement des substrats. Ces barrières thermiques permettent d'améliorer la différence de température entre le premier côté 104 et le deuxième côté 105 du dispositif thermoélectrique 100 en limitant les échanges thermiques entre le premier côté 104 et le deuxième côté 105. Notamment, les première et deuxième couches 114, 115 en matériau diélectrique de chaque substrat 109a, 109b, 109c, 109d (ainsi que la couche en matériau diélectrique de chacun des substrats d'extrémité) peuvent être en dioxyde de silicium ($SiO_2$), ou en nitrure de silicium ($Si_3N_4$), ou tout autre diélectrique permettant d'assurer la liaison entre deux substrats adjacents de l'empilement 108 de substrats et/ou la fonction de barrière thermique, et peuvent présenter chacune une épaisseur comprise entre 200nm et 10$\mu$m.

Selon une autre formulation, pour tout couple de substrats adjacents de l'empilement 108 de substrats (en figure 3 trois couples sont représentés : substrat 109a et substrat 109b ; substrat 109b et substrat 109c, substrat 109c et substrat 109d), les substrats dudit couple de substrats adjacents sont liés entre eux par liaisons covalentes :

- entre une couche en matériau diélectrique de l'un des substrats dudit couple de substrats adjacents et une couche en matériau diélectrique de l'autre des substrats dudit couple de substrats adjacents,
- entre le premier élément 110 de l'un des substrats dudit couple de substrats adjacents et le premier élément 110 de l'autre des substrats dudit couple de substrats adjacents, ces premiers éléments 110 appartenant à un même premier plot 101,
- entre le second élément 111 de l'un des substrats dudit couple de substrats adjacents et le second élément 111 de l'autre des substrats dudit couple de substrats adjacents, ces seconds éléments 111 appartenant à un même second plot 102.

Comme illustré en figure 3, chaque substrat 109a, 109b, 109c, 109d de l'empilement 108 de substrats peut comporter un support 117, par exemple en silicium, et chaque substrat 109b, 109c, 109d comportant les première et deuxième couches 114, 115 en matériau diélectrique est tel que :

- ses première et deuxième couches 114, 115 sont formées sur le support 117 qu'il comporte,
- les premier et second éléments 110 et 111 dudit substrat sont chacun isolé électriquement du support 117 dudit substrat par une gaine 118, 119 en matériau diélectrique,
- la gaine 118 entourant le premier élément 110 est formée par la première couche 114 en matériau diélectrique dudit substrat, et cette gaine 118 s'étend jusqu'à la deuxième couche 115 en matériau diélectrique dudit substrat,
- la gaine 119 entourant le second élément 111 relie la première couche 114 en matériau diélectrique dudit substrat à la deuxième couche 115 en matériau diélectrique dudit substrat.

Comme visible sur la figure 3, des gaines 118, 119 en matériau diélectrique peuvent aussi isoler les premier et second éléments 110, 111 des substrats d'extrémité 109a, 109b par rapport à un support 117 en silicium de ces derniers. L'avantage de ces gaines est de permettre une isolation électrique et thermique. Cet avantage des gaines 118, 119 est notamment conféré lorsque les gaines sont chacune formée par une couche présentant, de manière sensiblement orthogonale à la direction d'empilement des substrats, une épaisseur comprise entre 200nm et 20$\mu$m. Le matériau des gaines peut être du dioxyde de silicium ($SiO_2$), ou du nitrure de silicium ($Si_3N_4$).

De manière plus générale, pour tout substrat de l'empilement 108 de substrats, situé entre les deux substrats d'extrémité 109a, 109d de l'empilement 108 de substrats, les première et deuxième couches 114, 115 en matériau diélectrique dudit substrat sont formées sur le, notamment de part et d'autre du, support 117 dudit substrat, ce support 117 étant traversé par les premier et second plots 101, 102. Par exemple, les première et deuxième couches 114, 115 en matériau diélectrique d'un substrat correspondant sont formées par oxydation partielle du support 117 du substrat correspondant selon son épaisseur, ou par dépôt d'un matériau adapté sur ce support 117. Ceci peut aussi s'appliquer pour les couches en matériau diélectrique participant à délimiter les faces d'assemblage des substrats d'extrémité 109a, 109d. Le support 117 appartient au substrat 109a, 109b, 109c, 109d, il permet notamment la fonction de support mécanique à partir duquel sont formés les autres parties du substrat.

Il a été évoqué ci-dessus la fonction de barrière thermique des première(s) et deuxième(s) couches 114, 115. De préférence, pour améliorer cet effet de barrière thermique, pour tout substrat de l'empilement 108 de substrats, situé entre les deux substrats d'extrémité 109a, 109d de l'empilement 108 de substrats, la première couche 114 en matériau diélectrique dudit substrat présente une conductivité électrique strictement inférieure à celle du support 117 sur lequel elle est formée, et la deuxième couche 115 en matériau diélectrique dudit substrat présente une conductivité électrique strictement inférieure à celle du support 117 sur lequel elle est formée. Du fait de cette conduction électrique strictement inférieure, la conduction thermique de chacune des première et deuxième couches 114, 115 est strictement inférieure à celle du support 117 sur lequel elles sont formées.

La jonction thermoélectrique 103 peut comporter (par exemple voir figure 3) l'élément de liaison 106 électriquement conducteur relié aux premier et second plots 101, 102, notamment à une portion en siliciure 120a du premier plot 101 et à une portion en siliciure 120b du second plot 102. Le siliciure est un composé du silicium et d'un ou plusieurs éléments métalliques comme par exemple le titane. Les portions en siliciure 120a, 120b permettent d'améliorer les contacts électriques entre l'élément de liaison 106 et les premier et second plots 101, 102 de la jonction thermoélectrique 103, en particulier lorsque les premiers et seconds éléments des substrats 109a, 109b, 109c, 109d sont en matériau dopé électriquement in-situ. Les portions en siliciure 120a, 120b sont notamment formées aux extrémités des premier et second plots 101, 102 mises en contact avec l'élément de liaison 106. Les portions en siliciure 120a, 120b peuvent présenter chacune une épaisseur, selon la direction d'empilement des substrats, comprise entre 10nm et 1µm, ou entre 10nm et 500nm.

L'élément de liaison 106 peut présenter une épaisseur, selon la direction d'empilement des substrats 109a, 109b, 109c, 109d, comprise 100nm et 50µm. Le cas échéant, cette caractéristique peut aussi s'appliquer à l'élément de connexion 107.

En complément, et pour les mêmes raisons que pour l'élément de liaison 106, lorsque des jonctions thermoélectriques 103 sont reliées entre elles par un élément de connexion 107, des portions en siliciure 121a, 121b (figure 3) appartenant respectivement aux premier et second plots 101, 102 peuvent être en contact avec l'élément de connexion 107. Ce qui s'applique aux portions en siliciure 120a, 120b s'applique aussi aux portions en siliciure 121a, 121b.

Selon un exemple particulier, les substrats 109a, 109b, 109c, 109d présentent chacun une épaisseur de 100µm, et comportent chacun une pluralité de premiers éléments 110 et de seconds éléments 111 ayant chacun un diamètre, pris dans le plan du substrat de 5 µm, et une dimension mesurée selon l'épaisseur de du substrat de 100µm. En prenant des substrats 109a, 109b, 109c, 109d dont les première et deuxième faces opposées forment des carrés de dimensions 5mm par 5mm (soit une surface de 25mm$^2$), il est possible de loger un total de 10$^6$ premiers et seconds éléments par substrat 109a, 109b, 109c, 109d. En supposant qu'un substrat 109a, 109b, 109c, 109d permet de d'obtenir une différence de température de 1°C, en prenant un empilement de dix substrats 109a, 109b, 109c, 109d, la différence de température entre le côté chaud et le côté froid peut atteindre 10°C. Selon cet exemple, il est possible d'obtenir, selon les matériaux utilisés, 0.4µW généré par le dispositif thermoélectrique soumis à la différence de température de 10°C. A surface équivalente et matériaux équivalents, et selon une technologie 3D pour laquelle le dispositif thermoélectrique 100 peut comporter des plots dont la dimension, notamment la hauteur, entre le premier côté et le deuxième côté du dispositif thermoélectrique est de 2µm, la différence de température est d'environ 0,1°C d'où il résulterait que le dispositif thermoélectrique génère seulement 20nW, soit un facteur 20 de différence avec la technologie proposée selon l'exemple particulier.

La figure 4 est une vue éclatée d'un empilement de quatre substrats permettant de former une pluralité de jonctions thermoélectriques du dispositif thermoélectrique 100. Sur cette figure 4, les substrats 109a, 109b, 109c, 109d sont tels que leur empilement permet de former des empilements de premiers et seconds éléments 110, 111 qui seront ensuite reliés en utilisant des éléments de liaison 106 pour former des jonctions thermoélectriques (au nombre de neuf en figure 4), ensuite reliées en série par des éléments de connexion 107.

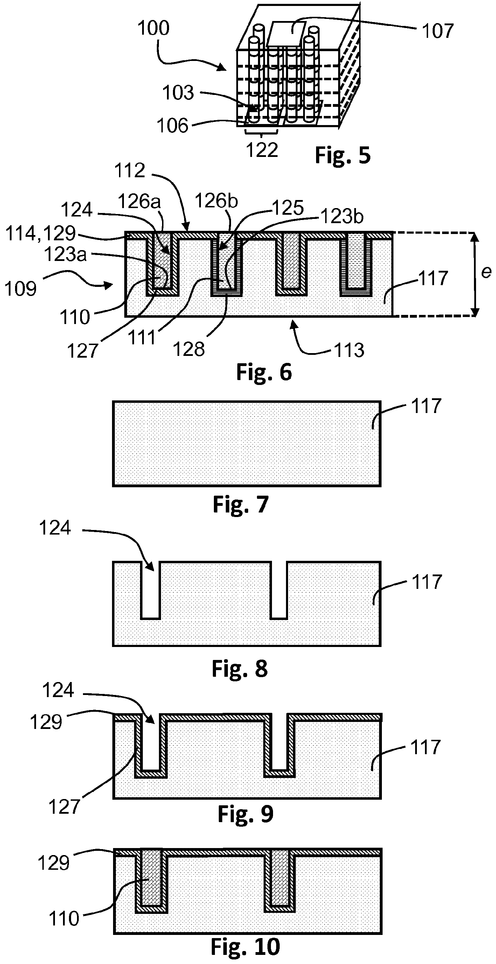

Il est aussi possible d'adapter les connexions électriques entre plots. Par « adapter les connexions électriques entre plots », on entend qu'il est possible de jouer sur des configurations série et parallèle. En général, les jonctions thermoélectriques du dispositif thermoélectrique 100 sont reliées électriquement en série comme cela est par exemple représenté en figure 4. Cependant, il est parfois judicieux de réaliser des connexions électriques en parallèles, notamment lorsqu'il y a beaucoup de jonctions thermoélectriques. En effet, si une connexion métallique (élément de liaison ou élément de connexion) venait à être défaillante, le dispositif thermoélectrique 100 entier ne fonctionnerait plus. De plus, jouer sur un couplage de connexions série et parallèle ne change pas la puissance électrique totale générée par le dispositif thermoélectrique fonctionnant en mode Seebeck car ce sont les tensions/résistances/courant qui changent. Ainsi, comme illustré en figure 5, le dispositif thermoélectrique 100 (par exemple à empilement de six substrats comme illustré en figure 5) peut comporter des ensembles 122 de jonctions thermoélectriques 103 tels que, au sein de chaque ensemble 122 de jonctions thermoélectriques 103, les jonctions thermoélectriques 103 dudit ensemble 122 sont reliées électriquement en parallèle (notamment un élément de liaison 106), lesdits ensembles 122 de jonctions thermoélectriques 103 étant reliés électriquement en série (notamment par un élément de connexion 107).

Selon une réalisation, il est possible de connecter ensemble plusieurs dispositifs thermoélectriques 100 tels que décrits par exemple pour augmenter la puissance totale d'énergie récupérée lorsque les dispositifs thermoélectriques 100 sont des générateurs d'énergie électrique. Pour cela, les dispositifs peuvent être fixés à un même support de liaison permettant de relier électriquement les dispositifs thermoélectriques entre eux.

On comprend de ce qui a été décrit ci-dessus que l'invention est aussi relative à un procédé de fabrication du dispositif thermoélectrique 100, notamment tel que décrit dans la présente description, comportant au moins une jonction thermoélectrique 103.

Le procédé de fabrication comporte une étape de fourniture de substrats 109, par exemple tel que visible en figure 6, chaque substrat fourni 109 comportant au moins un premier élément 110 et au moins un second élément 111 formés dans l'épaisseur e dudit substrat 109 (préférentiellement les premier et second éléments 110, 111 ne font pas saillie du substrat 109 mais affleurent à une face de ce dernier). Bien entendu, les premier et second éléments 110, 111 sont chacun en matériau thermoélectrique adapté. Le procédé de fabrication comporte en outre une étape de formation de l'empilement 108 de substrats (visible en figures 2 et 3) à partir des (c'est-à-dire en utilisant les) substrats fournis 109. Notamment, cet empilement 108 de substrats est un empilement de substrats dont les substrats sont ceux fournis, et ayant notamment subis des modifications au cours de la formation de l'empilement 108 de substrats. Il résulte de cette étape de formation de l'empilement 108 de substrats la formation du premier plot 101 de la jonction thermoélectrique 103 et du second plot 102 de la jonction thermoélectrique 103, le premier plot 101 comportant un empilement de premiers éléments 110 et le second plot 102 comportant un empilement de seconds éléments 111. Enfin, le procédé de fabrication comporte une étape de formation d'une connexion électrique de la jonction thermoélectrique 103, ladite connexion électrique reliant électriquement le premier plot 101 de la jonction thermoélectrique 103 au second plot 102 de la jonction thermoélectrique 103. En particulier, cette jonction thermoélectrique est formée entre le premier côté 104 du dispositif thermoélectrique 100 et le deuxième côté 105 du dispositif thermoélectrique 100. Cette connexion électrique est notamment formée à une des extrémités de l'empilement 108 de substrats, cette extrémité étant sensiblement orthogonale à la direction d'empilement des substrats. Bien entendu, lorsque le dispositif thermoélectrique 100 à fabriquer comporte plusieurs jonctions thermoélectriques 103, chaque substrat fourni 109 comporte une pluralité de premiers éléments 110 et une pluralité de seconds éléments 111.

De préférence, comme illustré en figure 6, chaque substrat fourni 109 est tel que ledit substrat 109 comporte des trous borgnes 124, 125 (aussi appelés trous non-débouchant) formés dans sa première face 112, les premier et second éléments 110, 111 dudit substrat 109 étant formés dans les trous borgnes 124, 125 de telle sorte que la première face 112 dudit substrat 109 comprend des parties 126a, 126b délimitées par les premier et second éléments 110, 111. Bien entendu, chaque substrat fourni comporte la deuxième face 113 opposée à sa première face 112. Notamment, le fond 123a, 123b de chaque trous borgnes 124, 125 est séparé de la deuxième face 113 du substrat 109 correspondant par des portions correspondantes du substrat 109, on comprend ainsi que l'épaisseur de chaque substrat fourni est strictement supérieure à celle des substrats empilés du dispositif thermoélectrique 100 au terme de sa fabrication. De préférence, chaque substrat 109 comporte le support 117 par exemple une tranche de semi-conducteur, notamment de silicium, aussi appelée plaquette, ou « wafer » en langue anglaise. Les trous borgnes 124, 125 sont formés dans l'épaisseur de cette tranche de semi-conducteur 117. Les premier et second éléments 110, 111 sont isolés électriquement de cette tranche de semi-conducteur par des fourreaux 127, 128 en matériau diélectrique notamment à partir desquels les gaines 118, 119 évoquées précédemment sont issues. Le matériau diélectrique des fourreaux 127, 128 peut donc être le même que celui des gaines 118, 119.

Il est à présent décrit un exemple d'étapes mises en œuvre pour obtenir les substrats 109 tels qu'ils sont fournis dans le cadre du procédé de fabrication. On comprend alors que le procédé de fabrication peut comporter une étape de formation des substrats 109 à fournir comportant, pour chaque substrat 109 à fournir les étapes décrites ci-après, et notamment successives :

- une étape de fourniture de la tranche de semi-conducteur 117 (figure 7),
- une première étape de retrait de matière dans l'épaisseur de la tranche de semi-conducteur 117, depuis l'une de ses faces opposées selon son épaisseur, pour former au moins un premier trou borgne 124 (figure 8) destiné à recevoir le premier élément 101 (en figure 8, deux premiers trous borgnes 124 sont formés),
- une première étape d'oxydation d'où il résulte la formation d'une couche d'oxyde 129 (figure 9), notamment d'oxyde de silicium, cette oxydation permettant d'obtenir ladite couche d'oxyde 129 à la face de la tranche de semi-conducteur 117 dans laquelle le premier trou borgne 124 a été formé, ladite couche d'oxyde 129 s'étendant dans le premier trou borgne 124 pour former le fourreau 127,
- une étape de dépôt d'un matériau, par exemple du polysilicium dopé in-situ de type N, pour remplir le premier trou borgne 124 et ainsi former le premier élément 110 (figure 10),

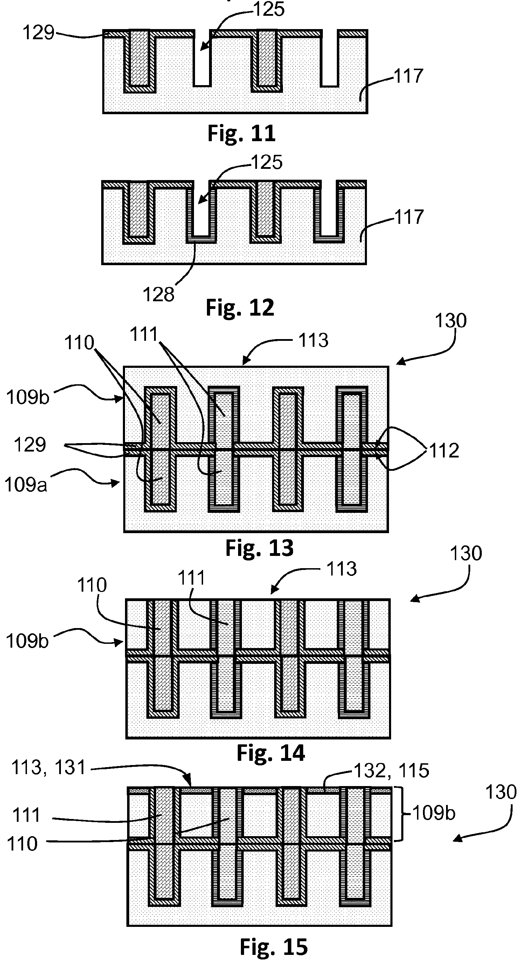

- éventuellement une étape de CMP (« Chemical Mechnical planarization» en langue anglaise, correspondant à planarisation mécano-chimique en langue française) jusqu'à découvrir la surface de la couche d'oxyde 129 (figure 10) ayant pu être recouverte par le dépôt permettant de former le premier élément 110,
- une deuxième étape de retrait de matière dans l'épaisseur de la tranche de semi-conducteur 117 et retirant localement une portion de la couche d'oxyde 129 pour former au moins un deuxième trou borgne 125 destiné à recevoir le second élément 111, en figure 11, deux deuxièmes trous borgnes 125 sont formés,
- une deuxième étape d'oxydation de la tranche de semi-conducteur 117 depuis le deuxième trou borgne 125 (figure 12) d'où il résulte la formation du fourreau 128 évoqué précédemment,
- une étape de dépôt d'un matériau, par exemple du polysilicium dopé in-situ de type P, pour remplir le deuxième trou borgne 125, et ainsi former le second élément 111 (figure 6),
- éventuellement une étape de CMP jusqu'à découvrir la surface de la couche d'oxyde 129 ayant pu être recouverte par le dépôt permettant de former le second élément 111.

Les étapes de retrait de matière se font notamment selon les dimensions souhaitées des premier et second éléments 110, 111. Le résultat des figures 8 et 11 peut avoir été obtenu à l'aide d'étapes de photolithographie et de gravure. La première couche 114 en matériau diélectrique des substrats de l'empilement 108 est notamment issue de cette couche d'oxyde 129. De manière plus générale, la couche d'oxyde 129 peut être une couche en matériau diélectrique obtenue par dépôt ou oxydation de sorte à former la première couche 114 en matériau diélectrique. En cas de dépôt de cette couche en matériau diélectrique, elle recouvre des parties des premier et second éléments en saillie de la tranche de semi-conducteur, puis une étape de CMP débutée depuis la couche en matériau diélectrique permet d'obtenir la première face souhaitée du substrat correspondant en révélant des parties des premier et second éléments du substrat. Les fourreaux peuvent aussi avoir été obtenus par dépôt d'un matériau diélectrique ou par oxydation de la tranche. Ces étapes sont avantageuses car les techniques associées sont maîtrisées. Cependant, l'homme du métier est à même de mettre en œuvre d'autres étapes technologiques pour obtenir le substrat 109 tel qu'illustré en figure 6.

Selon une réalisation particulière du procédé de fabrication, l'étape de formation de l'empilement 108 de substrats comporte (figure 13) une étape de formation d'un assemblage 130 comprenant une étape de mise en contact des premières faces 112 de premier et deuxième substrats 109a, 109b issus des substrats fournis. On comprend alors que la mise en contact des premières faces 112 des premier et deuxième substrats 109a, 109b est telle que le premier élément 110 du premier substrat 109a est mis en contact avec le premier élément 110 du deuxième substrat 109b, et que le second élément 111 du premier substrat 109a est mis en contact avec le second élément 111 du deuxième substrat 109b : ceci permet d'empiler les premiers éléments 110 et les seconds éléments 111 en vue de former la jonction thermoélectrique 103 correspondante. De préférence, la couche en matériau diélectrique, notamment d'oxyde 129, du premier substrat 109a est mise en contact avec la couche en matériau diélectrique, notamment d'oxyde 129 du deuxième substrat 109b. Il résulte de cette mise en contact la formation de liaisons Van der Waals assurant le maintien du premier substrat 109a au deuxième substrat 109b. De préférence, pour améliorer le maintien du premier substrat 109a par rapport au deuxième substrat 109b, l'assemblage est recuit, par exemple à une température comprise entre 400°C et 1100°C (dépendante des matériaux de l'assemblage 130), pour réaliser des liaisons covalentes entre le premier substrat 109a et le deuxième substrat 109b.

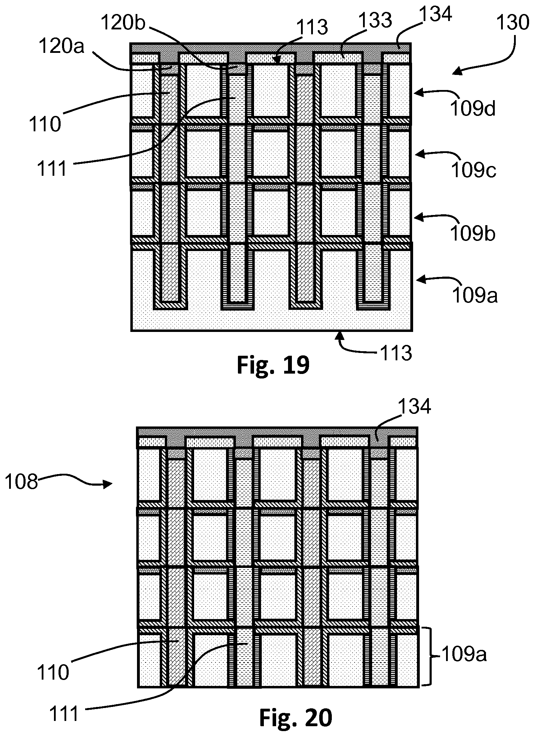

L'étape de formation de l'empilement 108 de substrats comporte en outre une étape de modification du deuxième substrat 109b de l'assemblage 130 (figures 13 à 15) d'où il résulte que sa deuxième face 113 présente, au terme de ladite étape de modification, des parties délimitées par les premier et second éléments 110, 111 du deuxième substrat 109b, ladite deuxième face 113 du deuxième substrat 109b tel que modifié formant une face de connexion 131 de l'assemblage 130. Notamment, l'étape de modification du deuxième substrat 109b peut comporter une étape d'amincissement du deuxième substrat 109b depuis sa deuxième face 113 (figure 13) de sorte à révéler des parties des premier et second éléments 110, 111 (figure 14) du deuxième substrat 109b. Autrement dit, l'amincissement est réalisé au moins depuis la deuxième face 113 du deuxième substrat 109b jusqu'au fond des trous borgnes 124, 125 du deuxième substrat 109b. Préférentiellement, après avoir révélé les parties des premier et second éléments 110, 111 du deuxième substrat 109b, une oxydation (figure 15) permet de former une couche d'oxyde 132 à la deuxième face 113 du deuxième substrat 109b. Cette couche d'oxyde 132 est notamment destinée à former la deuxième couche 115 évoquée précédemment. Cette oxydation peut ensuite être suivie d'une étape de CMP à la deuxième face du deuxième substrat 109b pour obtenir la deuxième face 113 telle que souhaitée du deuxième substrat 109b au sein de l'empilement 108. Alternativement, la couche d'oxyde 132 peut être remplacée par un dépôt d'une couche en matériau diélectrique, dans ce cas l'amincissement est généralement tel que des portions des premier et second élément 110, 111 font saillies, ensuite ces saillies sont recouvertes par la couche en matériau diélectrique avant qu'une étape de CMP à la deuxième face du deuxième substrat 109b vienne former la deuxième face 113 souhaitée du deuxième substrat 109b. L'étape de formation de l'empilement 108 comporte aussi une étape de modification du premier substrat 109a pour former un substrat d'extrémité 109a de l'empilement 108 de substrats. Cette étape de modification du premier substrat 109a comporte notamment une étape d'amincissement du premier substrat 109a jusqu'à révéler les parties des premier et second éléments 110, 111 du premier substrat 109a (figure 20).

Il résulte de ce qui a été décrit précédemment que l'empilement 108 de substrats peut être obtenu par assemblage et modification d'au moins trois substrats 109 ou plus. Ainsi, le nombre de substrats 109 utilisés pour former l'empilement 108 de substrats peut être adapté en fonction du dispositif thermoélectrique 100 souhaité et de ses caractéristiques. En particulier, si le nombre de substrats 109 fournis est supérieur ou égal à 3, on comprend qu'après avoir formé l'assemblage 130 (figure 15) à partir des premier et deuxième substrats 109a, 109b, tout substrat restant est ajouté à l'assemblage 130 en vue de former l'empilement 108 de substrats. Par la suite, on considère que chaque substrat non-intégré à l'assemblage 130 va être ajouté à l'assemblage 130. Ainsi, tout substrat « individuel » et dit « substrat à ajouter à l'assemblage » va être ajouté à l'assemblage 130 en utilisant la face de connexion 131 de l'assemblage 130, puis le substrat dernièrement ajouté sera modifié pour former une nouvelle face de connexion 131 de l'assemblage 130 destinée, le cas échéant, à recevoir un autre substrat à ajouter à l'assemblage ou à permettre la connexion électrique de plots d'une jonction thermoélectrique entre eux ou de jonctions thermoélectriques entre elles. Ainsi, le procédé de fabrication comporte, après l'étape de modification du deuxième substrat 109b, et pour chaque substrat fourni séparé de l'assemblage 130, dit substrat à ajouter à l'assemblage 130, une étape de modification de l'assemblage 130 comportant :

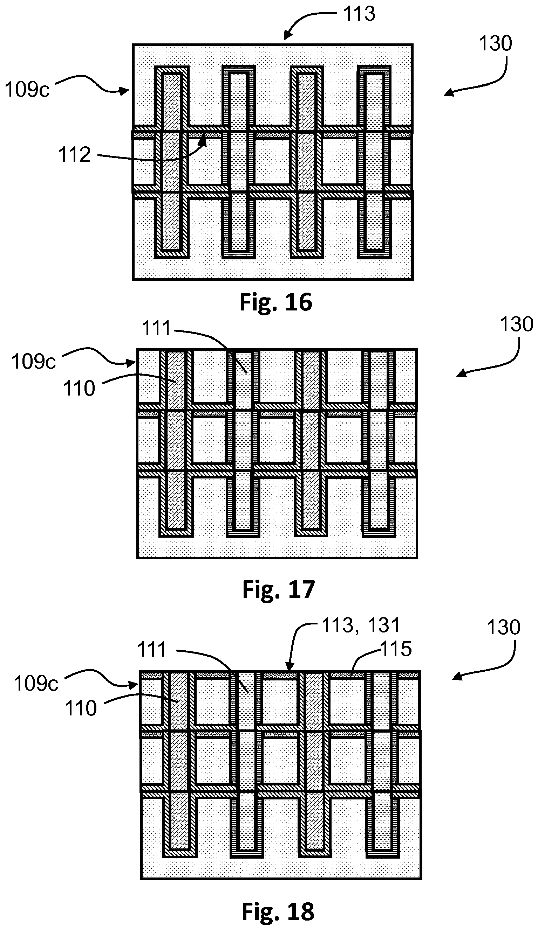

- une étape d'ajout du substrat 109c (figure 16) à ajouter à l'assemblage 130 par report de la première face 112 dudit substrat 109c à ajouter sur la face de connexion 131 de l'assemblage 130, puis
- une étape de modification dudit substrat ajouté 109c (c'est-à-dire le dernier substrat ajouté) à l'assemblage 130, notamment de telle sorte à former un des substrats de l'empilement 108 de substrats tel qu'illustré en figure 3. Ainsi, il résulte de l'étape de modification du substrat ajouté 109c (figures 17, 18) que sa deuxième face 113 comporte des parties délimitées par les premier et second éléments 110, 111 issus du substrat ajouté 109c à l'assemblage 130, cette deuxième face 113 du substrat 109c ajouté formant, au terme de la modification dudit substrat ajouté 109c, une nouvelle face de connexion 131 de l'assemblage 130.

Notamment, une fois la première face 112 du substrat ajouté 109c reportée sur, et donc en contact avec, la face de connexion 131, une étape de recuit telle que décrite précédemment peut être mise en œuvre pour fixer le substrat ajouté 109c à la face de connexion.

On comprend alors qu'une fois le premier substrat 109a monté au deuxième substrat 109b, l'étape de modification de l'assemblage est répétée z fois avec z un entier positif et tel que z = M-2, M étant le nombre de substrats fournis.

En particulier, chaque étape de modification du substrat ajouté comporte les étapes successives suivantes :

- une étape d'amincissement du substrat ajouté 109c depuis sa deuxième face 113 de sorte à révéler des parties des premier et second éléments 110, 111 dudit substrat ajouté (passage de la figure 16 à la figure 17), puis
- une étape de formation de la deuxième couche 115 en matériau diélectrique du substrat 109c, par exemple par oxydation du substrat 109c ajouté (figure 18) à partir d'une surface où s'est arrêté l'amincissement du substrat ajouté 109c.

Comme le montre la figure 19, une fois que tous les substrats 109a, 109b, 109c, 109d ont été ajoutés à l'assemblage 130, l'étape de modification liée au dernier des substrats ajoutés peut comporter une étape d'amincissement dudit substrat ajouté 109d depuis sa deuxième face 113 jusqu'à révéler des parties des premier et second éléments 110, 111 du dernier des substrats ajoutés 109d et former un premier substrat d'extrémité 109d de l'empilement 108 de substrats. Ensuite, les portions en silicium 120a, 120b sont préférentiellement formées dans les premier et second éléments 110, 111 du substrat 109d. Pour former ces portions en silicium 120a, 120b, le procédé de fabrication peut comporter les étapes successives :

- une étape de dépôt d'une couche en matériau diélectrique 133 sur la deuxième face 113 du premier substrat d'extrémité 109d de l'empilement 108 de substrats, par exemple cette couche en matériau diélectrique 133 est en dioxyde de silicium, ou en nitrure de silicium, et présente une épaisseur comprise entre 50nm et 500nm,
- une étape de gravure de la couche en matériau diélectrique 133 pour former des espaces dans la continuité des premier et second éléments 110, 111 du premier substrat d'extrémité 109d,
- une étape de dépôt, notamment pleine plaque, d'une bicouche par exemple comprenant une couche de titane et une couche de nitrure de titane telle que la couche de titane soit en contact avec les premier et second éléments 110, 111 en vue de former les portions en silicium 120a, 120b aux extrémités des premier et second éléments 110, 111 du premier substrat d'extrémité 109d, ces extrémités étant celles rendues accessibles par l'étape de gravure de la couche en matériau diélectrique 133,

- une étape de recuit, par exemple à une température comprise entre 400°C et 800°C, et plus particulièrement entre 700°C et 800°C pour obtenir du siliciure de titane, pour former les portions en siliciure, ces portions en siliciure étant formés par exemple par des liaisons Ti-Si,
- une étape de retrait de ce qu'il reste de la bicouche, ce restant correspondant à ce qui n'a pas réagi avec les premier et second éléments 110, 111 pour former les portions en siliciure 120a, 120b,
- une étape de dépôt d'une couche de protection 134 sacrificielle en matériau diélectrique sur la couche en matériau diélectrique 133 et les portions en siliciure 120a, 102b. La fonction de cette couche de protection 134 sacrificielle est de protéger les portions en siliciure lors d'étapes technologiques devant impacter une autre extrémité de l'empilement de substrats.

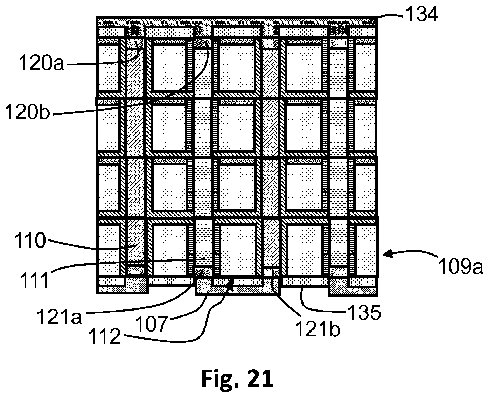

Après l'étape de dépôt de la couche de protection 134, l'étape de modification du premier substrat 109a peut être mise en œuvre d'où il résulte la formation d'un deuxième substrat d'extrémité 109a de l'empilement 108 de substrats (figure 20). Cette étape de modification peut être mise en œuvre par amincissement du premier substrat 109a depuis sa deuxième face 113 (figure 19) jusqu'à révéler des parties des premier et second éléments 110, 111 du premier substrat 109a (figure 20). Ensuite, (figure 21) les portions en siliciure 121a, 121b peuvent être formés dans les premier et second éléments 110, 111 du deuxième substrat d'extrémité 109a. Ces portions en siliciure 121a, 121b sont notamment formée à la manière de celles référencées 120a, 120b à partir d'une couche en matériau diélectrique 135 déposée sur le deuxième substrat d'extrémité de l'empilement de substrats (notamment sur la face référencée 112 en figure 21) et gravée dans le prolongement des premier et second éléments 110, 111 du deuxième substrat d'extrémité 109a. Enfin, après formations des portions en siliciure 121a, 121b, le ou les éléments de connexion 107 sont formés au contact des éléments en siliciure 121a, 121b (figure 21), et le ou les éléments de liaison 106 sont formés au contact des portions en siliciure 120a, 120b (figure 3) après retrait de la couche de protection 134. Les éléments de liaison 106 et de connexion 107 peuvent être en aluminium et obtenus par dépôt PVD (pour « physical vapor deposition » en langue anglaise) suivi de photolithographie, puis de gravure pour les délimiter. Alternativement, les éléments de liaison 106 et de connexion 107 peuvent être obtenus par électrolyse de type RDL pour « ReDistributionLayer » en langue anglaise, dans ce cas les éléments de liaison 106 et de connexion 107 peuvent comporter du cuivre et un alliage SnAg, ou du nickel et de l'or.

De manière générale, les dimensions des plots et le choix des matériaux pour les former est dépendant de l'application visée et de la différence de température escomptée.

Dans la présente description, ce qui s'applique au dispositif thermoélectrique peut s'appliquer au procédé de fabrication permettant son obtention, et inversement ce qui s'applique au procédé de fabrication du dispositif thermoélectrique peut s'appliquer au dispositif thermoélectrique décrit.

Le dispositif thermoélectrique tel que décrit présente une application industrielle notamment dans le domaine de la génération d'énergie électrique, ou dans le refroidissement de composants électroniques. Bien entendu, l'application industrielle d'un tel dispositif thermoélectrique peut aussi être étendue à tout domaine cherchant à exploiter un effet Seebeck ou un effet Peltier. Le procédé de fabrication s'applique tout particulièrement au domaine de la microélectronique pour fabriquer le dispositif thermoélectrique associé.

En particulier, le dispositif thermoélectrique tel que décrit peut être intégré de sorte à servir d'alimentation électrique pour capteur(s) autonome(s), pour composants microélectroniques, pour téléphone mobile, pour un actionneur domotique, pour capteur(s) d'un bâtiment intelligent, pour composant(s) situé(s) dans un réseau électrique intelligent aussi connu sous la dénomination anglaise « smart grid », ou encore dans le domaine de l'Internet des Objets (IoT pour « Internet of Things » en langue anglaise). En fait, lorsque le dispositif thermoélectrique est à effet Seebeck, c'est-à-dire à génération d'énergie électrique, il peut être utilisé pour servir d'alimentation électrique à tout composant, par exemple autonome et non relié à un réseau de distribution d'électricité, en exploitant une différence de température à laquelle il est soumis.

Dans le cas où le dispositif thermoélectrique est un générateur d'énergie électrique, il peut être relié à un convertisseur DC/DC permettant de convertir une tension continue en une autre tension continue de valeur différente. Dans ce cas, la mise en parallèle de certaines jonctions thermoélectriques permet de diminuer la tension générée par le dispositif thermoélectrique à une valeur d'entrée compatible avec le convertisseur DC/DC tout en conservant une puissance équivalente à celles des jonctions thermoélectriques en série.

## Revendications

1. Dispositif thermoélectrique (100) comportant :

- au moins une jonction thermoélectrique (103), ladite jonction thermoélectrique (103) comportant un premier plot (101) et un second plot (102) relié électriquement au premier plot (101),
- un empilement (108) de substrats, chaque substrat (109a, 109b, 109c, 109d) comportant au moins un premier élément (110) et au moins un second élément (111), le premier élément (110) et le second élément (111) étant formés dans l'épaisseur dudit substrat (109a, 109b, 109c, 109d),

l'empilement (108) de substrats étant tel que :

- le premier plot (101) de la jonction thermoélectrique (103) comporte un empilement de premiers éléments (110),
- le second plot (102) de la jonction thermoélectrique (103) comporte un empilement de seconds éléments (111),

l'empilement (108) de substrats comportant au minimum trois substrats, **caractérisé en ce que** tout substrat de l'empilement (108) de substrats, situé entre deux substrats d'extrémité (109a, 109d) de l'empilement (108) de substrats, comporte :

- une première face (112),
- une deuxième face (113) opposée à sa première face (112),
- une première couche (114) en matériau diélectrique délimitant une partie de la première face (112) dudit substrat,
- une deuxième couche (115) en matériau diélectrique délimitant une partie de la deuxième face (113) dudit substrat, les première et deuxième couches (114, 115) en matériau diélectrique dudit substrat étant traversées par les premier et second plots (101, 102).

2. Dispositif thermoélectrique (100) selon la revendication précédente, **caractérisé en ce que**, pour tout substrat de l'empilement (108) de substrats, situé entre les deux substrats d'extrémité (109a, 109d) de l'empilement (108) de substrats, les première et deuxième couches (114, 115) en matériau diélectrique dudit substrat sont formées sur, et notamment de part et d'autre, d'un support (117) dudit substrat.

3. Dispositif thermoélectrique (100) selon la revendication précédente, **caractérisé en ce que**, pour tout substrat de l'empilement (108) de substrats, situé entre les deux substrats d'extrémité (109a, 109d) de l'empilement (108) de substrats, la première couche (114) en matériau diélectrique dudit substrat présente une conductivité électrique strictement inférieure à celle du support (117) sur lequel elle est formée, et la deuxième couche (115) en matériau diélectrique dudit substrat présente une conductivité électrique strictement inférieure à celle du support (117) sur lequel elle est formée.

4. Dispositif thermoélectrique (100) selon l'une quelconque des revendications précédentes, **caractérisé en ce que** la jonction thermoélectrique (103) comporte un élément de liaison (106) électriquement conducteur relié à une portion en siliciure (120a) du premier plot (101) de la jonction thermoélectrique (103) et à une portion en siliciure (120b) du second plot (102) de la jonction thermoélectrique (103).

5. Dispositif thermoélectrique (100) selon l'une quelconque des revendications précédentes, **caractérisé en ce que** chaque substrat (109a, 109b, 109c, 109d) de l'empilement (108) de substrats comporte des vias traversants formant les premier et second éléments (110, 111) dudit substrat (109a, 109b, 109c, 109d).

6. Dispositif thermoélectrique (100) selon l'une quelconque des revendications précédentes, **caractérisé en ce qu'**il comporte :

- des premiers et des seconds plots (101, 102),
- une pluralité de jonctions thermoélectriques (103) comportant chacune un des premiers plots (101) et un des seconds plots (102),

et **en ce que** chaque substrat (109a, 109b, 109c, 109d) comporte des premiers et des seconds éléments (110, 111), l'empilement (108) de substrats étant tel que :

- chaque premier plot (101) comporte un empilement de premiers éléments (110),
- chaque second plot (102) comporte un empilement de seconds éléments (111).

7. Dispositif thermoélectrique (100) selon la revendication précédente, **caractérisé en ce que** les jonctions thermoélectriques (103) sont reliées électriquement en série.

8. Dispositif thermoélectrique (100) selon la revendication 6, **caractérisé en ce qu'**il comporte des ensembles (122) de jonctions thermoélectriques (103) tels que, au sein de chaque ensemble (122) de jonctions thermoélectriques (103), les jonctions thermoélectriques (103) dudit ensemble (122) sont reliées électriquement en parallèle, lesdits ensembles (122) de jonctions thermoélectriques (103) étant reliés électriquement en série.

9. Dispositif thermoélectrique (100) selon l'une quelconque des revendications précédentes, **caractérisé en ce que** les substrats (109a, 109b, 109c, 109d) de l'empilement (108) de substrats sont liés par des liaisons covalentes.

10. Procédé de fabrication d'un dispositif thermoélectrique (100) comprenant au moins une jonction thermoélectrique (103), ledit procédé de fabrication comportant :

- une étape de fourniture de substrats (109), chaque substrat (109) fourni comportant au moins un premier élément (110) et au moins un second élément (111) formés dans son épaisseur,
- une étape de formation d'un empilement (108) de substrats en utilisant les substrats (109) fournis d'où il résulte la formation d'un premier plot (101) de la jonction thermoélectrique (103) et d'un second plot (102) de la jonction thermoélectrique (103), le premier plot (101) comportant un empilement de premiers éléments (110) et le second plot (102) comportant un empilement de seconds éléments (111),
- une étape de formation d'une connexion électrique de la jonction thermoélectrique (103), ladite connexion électrique reliant électriquement le premier plot (101) au second plot (102),

l'empilement (108) de substrats comportant au minimum trois substrats, **caractérisé en ce que** tout substrat de l'empilement (108) de substrats, situé entre deux substrats d'extrémité (109a, 109d) de l'empilement (108) de substrats, comporte :

- une première face (112),
- une deuxième face (113) opposée à sa première face (112),
- une première couche (114) en matériau diélectrique délimitant une partie de la première face (112) dudit substrat,
- une deuxième couche (115) en matériau diélectrique délimitant une partie de la deuxième face (113) dudit substrat, les première et deuxième couches (114, 115) en matériau diélectrique dudit substrat étant traversées par les premier et second plots (101, 102).

**11.** Procédé de fabrication selon la revendication précédente, **caractérisé en ce que** chaque substrat (109) fourni est tel que :

- ledit substrat (109) comporte une première face (112) dans laquelle sont formés des trous borgnes (124, 125), les premier et second éléments (110, 111) dudit substrat (109) étant formés dans les trous borgnes (124, 125) de telle sorte que la première face (112) dudit substrat (109) comprend des parties (126a, 126b) délimitées par les premier et second éléments (110, 111),
- ledit substrat (109) comporte une deuxième face (113) opposée à sa première face (112),

et **en ce que** l'étape de formation de l'empilement (108) de substrats comporte :

- une étape de formation d'un assemblage (130) comprenant une étape de mise en contact des premières faces (112) de premier et deuxième substrats (109a, 109b) issus des substrats fournis,
- une étape de modification du deuxième substrat (109b) de l'assemblage (130) d'où il résulte que sa deuxième face (113) présente des parties délimitées par les premier et second éléments (110, 111) du deuxième substrat (109b), ladite deuxième face (113) du deuxième substrat (109b) tel que modifié formant une face de connexion (131) de l'assemblage (130),
- une étape de modification du premier substrat (109a) pour former un substrat d'extrémité (109a) de l'empilement (108) de substrats.

**12.** Procédé de fabrication selon la revendication précédente, **caractérisé en ce qu'**il comporte, après l'étape de modification du deuxième substrat (109b) et pour chaque substrat fourni séparé de l'assemblage (130), dit substrat à ajouter à l'assemblage (130), une étape de modification de l'assemblage (130) comportant :

- une étape d'ajout du substrat à ajouter (109c) à l'assemblage (130) par report de la première face (112) dudit substrat à ajouter (109c) sur la face de connexion (131) de l'assemblage (130),
- une étape de modification dudit substrat ajouté (109c) à l'assemblage (130) d'où il résulte que sa deuxième face (113) présente des parties délimitées par les premier et second éléments (110, 111) du substrat ajouté (109c) à l'assemblage (130), ladite deuxième face (113) formant, au terme de la modification dudit substrat ajouté (109c), une nouvelle face de connexion (131) de l'assemblage (130).

**Patentansprüche**

**1.** Thermoelektrische Vorrichtung (100), aufweisend:

- mindestens einen thermoelektrischen Kontakt (103), wobei der thermoelektrische Kontakt (103) ein erstes Klötzchen (101) und ein zweites Klötzchen (102), das mit dem ersten Klötzchen (101) elektrisch verbunden ist, aufweist,
- einen Stapel (108) von Substraten, wobei jedes Substrat (109a, 109b, 109c, 109d) mindestens ein erstes Element (110) und mindestens ein zweites Element (111) aufweist, wobei das erste Element (110) und das zweite Element (111) in der Dicke des Substrats (109a, 109b, 109c, 109d) ausgebildet sind,

wobei der Stapel (108) von Substraten so beschaffen ist, dass:

- das erste Klötzchen (101) des thermoelektrischen Kontakts (103) einen Stapel erster Elemente (110) aufweist,
- das zweite Klötzchen (102) des thermoelektrischen Kontakts (103) einen Stapel zweiter Elemente (111) aufweist,

wobei der Stapel (108) von Substraten mindestens drei Substrate aufweist, **dadurch gekennzeichnet, dass** jedes Substrat des Stapels (108) von Substraten, das sich zwischen zwei Endsubstraten (109a, 109d) des Stapels (108) von Substraten befindet, Folgendes aufweist:

- eine erste Seite (112),
- eine zweite Seite (113), die seiner ersten Seite (112) gegenüberliegt,
- eine erste Schicht (114) aus dielektrischem Material, die einen Abschnitt der ersten Seite (112) des Substrats begrenzt,
- eine zweite Schicht (115) aus dielektrischem Material, die einen Abschnitt der zweiten Seite (113) des Substrats begrenzt, wobei die erste und zweite Schicht (114, 115) aus dielektrischem Material von dem ersten und zweiten Klötzchen (101, 102) durchquert werden.

2. Thermoelektrische Vorrichtung (100) nach dem vorhergehenden Anspruch, **dadurch gekennzeichnet, dass** für jedes Substrat des Stapels (108) von Substraten, das sich zwischen den zwei Endsubstraten (109a, 109d) des Stapels (108) von Substraten befindet, die erste und zweite Schicht (114, 115) aus dielektrischem Material des Substrats auf und insbesondere beiderseits von einem Träger (117) des Substrats ausgebildet sind.

3. Thermoelektrische Vorrichtung (100) nach dem vorhergehenden Anspruch, **dadurch gekennzeichnet, dass** für jedes Substrat des Stapels (108) von Substraten, das sich zwischen den zwei Endsubstraten (109a, 109d) des Stapels (108) von Substraten befindet, die erste Schicht (114) aus dielektrischem Material des Substrats eine elektrische Leitfähigkeit aufweist, die streng kleiner als jene des Trägers (117) ist, auf dem sie ausgebildet ist, und die zweite Schicht (115) aus dielektrischem Material des Substrats eine elektrische Leitfähigkeit aufweist, die streng kleiner als jene des Trägers (117) ist, auf dem sie ausgebildet ist.

4. Thermoelektrische Vorrichtung (100) nach einem der vorhergehenden Ansprüche, **dadurch gekennzeichnet, dass** der thermoelektrische Kontakt (103) ein elektrisch leitendes Verbindungselement (106) aufweist, das mit einem Teilbereich aus Silicid (120a) des ersten Klötzchens (101) des thermoelektrischen Kontakts (103) und einem Teilbereich aus Silicid (120b) des zweiten Klötzchens (102) des thermoelektrischen Kontakts (103) verbunden ist.

5. Thermoelektrische Vorrichtung (100) nach einem der vorhergehenden Ansprüche, **dadurch gekennzeichnet, dass** jedes Substrat (109a, 109b, 109c, 109d) des Stapels (108) von Substraten Durchkontaktierungen aufweist, die das erste und zweite Element (110, 111) des Substrats (109a, 109b, 109c, 109d) bilden.

6. Thermoelektrische Vorrichtung (100) nach einem der vorhergehenden Ansprüche, **dadurch gekennzeichnet, dass** sie Folgendes aufweist:

- erste und zweite Klötzchen (101, 102),
- eine Mehrzahl von thermoelektrischen Kontakten (103), jeweils aufweisend eins der ersten Klötzchen (101) und eins der zweiten Klötzchen (102),

und dadurch, dass jedes Substrat (109a, 109b, 109c, 109d) erste und zweite Elemente (110, 111) aufweist, wobei der Stapel (108) von Substraten so beschaffen ist, dass:

- jedes erste Klötzchen (101) einen Stapel erster Elemente (110) aufweist,
- jedes zweite Klötzchen (102) einen Stapel zweiter Elemente (111) aufweist.

7. Thermoelektrische Vorrichtung (100) nach dem vorhergehenden Anspruch, **dadurch gekennzeichnet, dass** die thermoelektrischen Kontakte (103) elektrisch in Reihe geschaltet sind.

8. Thermoelektrische Vorrichtung (100) nach Anspruch 6, **dadurch gekennzeichnet, dass** sie Anordnungen (122) thermoelektrischer Kontakte (103) aufweist, die so beschaffen sind, dass innerhalb jeder Anordnung (122) thermoelektrischer Kontakte (103) die thermoelektrischen Kontakte (103) der Anordnung (122) elektrisch parallel geschaltet sind, wobei die Anordnungen (122) thermoelektrischer Kontakte (103) elektrisch in Reihe geschaltet sind.

9. Thermoelektrische Vorrichtung (100) nach einem der vorhergehenden Ansprüche, **dadurch gekennzeichnet, dass** die Substrate (109a, 109b, 109c, 109d) des Stapels (108) von Substraten durch kovalente Bindungen verbunden sind.

10. Verfahren zur Herstellung einer thermoelektrischen Vorrichtung (100) umfassend mindestens einen thermoelektrischen Kontakt (103), das Herstellungsverfahren aufweisend:

- einen Schritt des Bereitstellens von Substraten (109), wobei jedes bereitgestellte Substrat (109) mindestens ein erstes Element (110) und mindestens ein zweites Element (111) aufweist, die in seiner Dicke ausgebildet sind,
- einen Schritt des Bildens eines Stapels (108) von Substraten unter Verwendung der bereitgestellten Substrate (109), woraus die Bildung eines ersten Klötzchens (101) des thermoelektrischen Kontakts (103) und eines zweiten Klötzchens (102) des thermoelektrischen Kontakts (103) hervorgeht, wobei das erste Klötzchen (101) einen Stapel erster Elemente (110) und das zweite Klötzchen (102) einen Stapel zweiter Elemente (111) aufweist,
- einen Schritt des Bildens einer elektrischen Verbindung des thermoelektrischen Kontakts (103), wobei die elektrische Verbindung das erste Klötzchen (101) mit dem zweiten Klötzchen (102) verbindet,

wobei der Stapel (108) von Substraten mindestens drei Substrate aufweist, **dadurch gekennzeichnet, dass** jedes Substrat des Stapels (108) von Substraten, das sich zwischen zwei Endsubstraten (109a, 109d) des Stapels (108) von Substraten befindet, Folgendes aufweist:

- eine erste Seite (112),
- eine zweite Seite (113), die seiner ersten Seite (112) gegenüberliegt,
- eine erste Schicht (114) aus dielektrischem Material, die einen Abschnitt der ersten Seite (112) des Substrats begrenzt,
- eine zweite Schicht (115) aus dielektrischem Material, die einen Abschnitt der zweiten Seite (113) des Substrats begrenzt, wobei die erste und zweite Schicht (114, 115) aus dielektrischem Material von dem ersten und zweiten Klötzchen (101, 102) durchquert werden.

11. Herstellungsverfahren nach dem vorhergehenden Anspruch, **dadurch gekennzeichnet, dass** jedes bereitgestellte Substrat (109) so beschaffen ist, dass:

- das Substrat (109) eine erste Seite (112) aufweist, in welcher Sacklöcher (124, 125) ausgebildet sind, wobei das erste und zweite Element (110, 111) des Substrats (109) so in den Sacklöchern (124, 125) ausgebildet sind, dass die erste Seite (112) des Substrats (109) Abschnitte (126a, 126b) umfasst, die vom ersten und zweiten Element (110, 111) begrenzt sind,
- das Substrat (109) eine zweite Seite (113) aufweist, die seiner ersten Seite (112) gegenüberliegt,

und dadurch, dass der Schritt des Bildens des Stapels (108) von Substraten Folgendes aufweist:

- einen Schritt des Bildens einer Zusammensetzung (130), umfassend einen Schritt des Inkontaktbringens der ersten Seiten (112) ersten und zweiten Substrats (109a, 109b) aus den bereitgestellten Substraten,
- einen Schritt des Veränderns des zweiten Substrats (109b) der Zusammensetzung (130), woraus hervorgeht, dass seine zweite Seite (113) Abschnitte aufweist, die vom ersten und zweiten Element (110, 111) des zweiten Substrats (109b) begrenzt sind, wobei die zweite Seite (113) des veränderten zweiten Substrats (109b) eine Verbindungsseite (131) der Zusammensetzung (130) bildet,
- einen Schritt des Veränderns des ersten Substrats (109a), um ein Endsubstrat (109a) des Stapels (108) von Substraten zu bilden.

12. Herstellungsverfahren nach dem vorhergehenden Anspruch, **dadurch gekennzeichnet, dass** es nach dem Schritt des Veränderns des zweiten Substrats (109b) und für jedes bereitgestellte Substrat, das von der Zusammensetzung (130) getrennt ist, genannt das Substrat, das der Zusammensetzung (130) hinzuzufügen ist, einen Schritt des Veränderns der Zusammensetzung (130) aufweist, der Folgendes aufweist:

- einen Schritt des Hinzufügens des Substrats (109c), das der Zusammensetzung (130) hinzuzufügen ist, durch Ansetzen der ersten Seite (112) des hinzuzufügenden Substrats (109c) an die Verbindungsseite (131) der Zusammensetzung (130),
- einen Schritt des Veränderns des Substrats (109c), das der Zusammensetzung (130) hinzugefügt wurde, woraus hervorgeht, dass seine zweite Seite (113) Abschnitte aufweist, die vom ersten und zweiten Element (110, 111) des Substrats (109c), das der Zusammensetzung (130) hinzugefügt wurde, begrenzt sind, wobei die zweite Seite (113) am Ende des Veränderns des hinzugefügten Substrats (109c) eine neue Verbindungsseite (131) der Zusammensetzung (130) bildet.

**Claims**

1. Thermoelectric device (100) comprising:

- at least one thermoelectric junction (103), said thermoelectric junction (103) comprising a first leg (101) and a second leg (102) linked electrically to the first leg (101),

- a stack (108) of substrates, each substrate (109a, 109b, 109c, 109d) comprising at least one first element (110) and at least one second element (111), the first element (110) and the second element (111) being formed in the thickness of said substrate (109a, 109b, 109c, 109d),

the stack (108) of substrates being such that:

- the first leg (101) of the thermoelectric junction (103) comprises a stack of first elements (110),
- the second leg (102) of the thermoelectric junction (103) comprises a stack of second elements (111),

the stack (108) of substrates comprising at least three substrates, **characterized in that** any substrate of the stack (108) of substrates, situated between two end substrates (109a, 109d) of the stack (108) of substrates, comprises:

- a first face (112),
- a second face (113) opposite its first face (112),
- a first layer (114) of dielectric material delimiting a part of the first face (112) of said substrate,
- a second layer (115) of dielectric material delimiting a part of the second face (113) of said substrate, the first and second layers (114, 115) of dielectric material of said substrate being passed through by the first and second legs (101, 102).

2. Thermoelectric device (100) according to the preceding claim, **characterized in that**, for any substrate of the stack (108) of substrates, situated between the two end substrates (109a, 109d) of the stack (108) of substrates, the first and second layers (114, 115) of dielectric material of said substrate are formed on, and notably on either side of, a support (117) of said substrate.

3. Thermoelectric device (100) according to the preceding claim, **characterized in that**, for any substrate of the stack (108) of substrates, situated between the two end substrates (109a, 109d) of the stack (108) of substrates, the first layer (114) of dielectric material of said substrate has an electrical conductivity strictly lower than that of the support (117) on which it is formed, and the second layer (115) of dielectric material of said substrate has an electrical conductivity strictly lower than that of the support (117) on which it is formed.

4. Thermoelectric device (100) according to any one of the preceding claims, **characterized in that** the thermoelectric junction (103) comprises an electrically conductive link element (106) linked to a portion of silicide (120a) of the first leg (101) of the thermoelectric junction (103) and to a portion of silicide (120b) of the second leg (102) of the thermoelectric junction (103).

5. Thermoelectric device (100) according to any one of the preceding claims, **characterized in that** each substrate (109a, 109b, 109c, 109d) of the stack (108) of substrates comprises through vias forming the first and second elements (110, 111) of said substrate (109a, 109b, 109c, 109d).

6. Thermoelectric device (100) according to any one of the preceding claims, **characterized in that** it comprises:

- first and second legs (101, 102),
- a plurality of thermoelectric junctions (103) each comprising one of the first legs (101) and one of the second legs (102),

and **in that** each substrate (109a, 109b, 109c, 109d) comprises first and second elements (110, 111), the stack (108) of substrates being such that:

- each first leg (101) comprises a stack of first elements (110),
- each second leg (102) comprises a stack of second elements (111).

7. Thermoelectric device (100) according to the preceding claim, **characterized in that** the thermoelectric junctions (103) are electrically linked in series.

8. Thermoelectric device (100) according to Claim 6, **characterized in that** it comprises sets (122) of thermoelectric junctions (103) such that, within each set (122) of thermoelectric junctions (103), the thermoelectric junctions (103) of said set (122) are electrically linked in parallel, said sets (122) of thermoelectric junctions (103) being electrically linked in series.

9. Thermoelectric device (100) according to any one of the preceding claims, **characterized in that** the substrates (109a, 109b, 109c, 109d) of the stack (108) of substrates are linked by covalent bonds.

10. Method for fabricating a thermoelectric device (100) comprising at least one thermoelectric junction (103), said fabrication method comprising:

- a step of supplying substrates (109), each substrate (109) supplied comprising at least one first element (110) and at least one second element (111) that are formed in its thickness,
- a step of forming a stack (108) of substrates by using the substrates (109) supplied which results in the formation of a first leg (101) of the thermoelectric junction (103) and of a second leg (102) of the thermoelectric junction (103), the first leg (101) comprising a stack of first elements (110) and the second leg (102) comprising a stack of second elements (111),
- a step of forming an electrical connection of the thermoelectric junction (103), said electrical connection electrically linking the first leg (101) to the second leg (102),

the stack (108) of substrates comprising at least three substrates, **characterized in that** any substrate of the stack (108) of substrates, situated between two end substrates (109a, 109d) of the stack (108) of substrates, comprises:

- a first face (112),
- a second face (113) opposite its first face (112),
- a first layer (114) of dielectric material delimiting a part of the first face (112) of said substrate,
- a second layer (115) of dielectric material delimiting a part of the second face (113) of said substrate, the first and second layers (114, 115) of dielectric material of said substrate being passed through by the first and second legs (101, 102).

11. Fabrication method according to the preceding claim, **characterized in that** each substrate (109) supplied is such that:

- said substrate (109) comprises a first face (112) in which blind holes (124, 125) are formed, the first and second elements (110, 111) of said substrate (109) being formed in the blind holes (124, 125) such that the first face (112) of said substrate (109) comprises parts (126a, 126b) delimited by the first and second elements (110, 111),
- said substrate (109) comprises a second face (113) opposite its first face (112),

and **in that** the step of forming the stack (108) of substrates comprises:

- a step of forming an assembly (130) comprising a step of bringing first faces (112) of first and second substrates (109a, 109b) from the substrates supplied into contact,
- a step of modifying the second substrate (109b) of the assembly (130) which results **in that** its second face (113) has parts delimited by the first and second elements (110, 111) of the second substrate (109b), said second face (113) of the second substrate (109b) as modified forming a connection face (131) of the assembly (130),
- a step of modifying the first substrate (109a) to form an end substrate (109a) of the stack (108) of substrates.

12. Fabrication method according to the preceding claim, **characterized in that** it comprises, after the step of modifying the second substrate (109b) and for each substrate supplied separate from the assembly (130), called substrate to be added to the assembly (130), a step of modifying the assembly (130) comprising:

- a step of adding the substrate to be added (109c) to the assembly (130) by transferring the first face (112) of said substrate to be added (109c) to the connection face (131) of the assembly (130),
- a step of modifying said substrate (109c) added to the assembly (130) which results **in that** its second face (113) has parts delimited by the first and second elements (110, 111) of the substrate (109c) added to the assembly (130), said second face (113) forming, at the end of the modification of said added substrate (109c), a new connection face (131) of the assembly (130).

Fig. 1 (Art Antérieur)

Fig. 2

120a  106  120b     117            104
100    103

113

115                                     116b
114                                      109d
112                                      109c
101                                      108
110                                      109b
                                         116a
111   105        118  119  121b          109a
      121a   107

**Fig. 3**

100

107                                      109a

                                         109b

                                         109c

                                         109d
110   111
106        **Fig. 4**

**Fig. 5**

**Fig. 6**

**Fig. 7**

**Fig. 8**

**Fig. 9**

**Fig. 10**

129 — 125

117

**Fig. 11**

125

117

128

**Fig. 12**

110   111   113   130

109b

129   112

109a

**Fig. 13**

110   111   113   130

109b

**Fig. 14**

113, 131   132, 115   130

111   109b

110

**Fig. 15**

**Fig. 16**

**Fig. 17**

**Fig. 18**

**Fig. 19**

**Fig. 20**

**Fig. 21**

**EP 3 506 375 B1**

## RÉFÉRENCES CITÉES DANS LA DESCRIPTION

**Documents brevets cités dans la description**

- EP 1988584 A1
- WO 2009063805 A1